# EUROPEAN PATENT APPLICATION

(11) **EP 3 926 691 A1**
(43) Date of publication of application: **22.12.2021**
(21) Application number: 20756314.9
(22) Date of filing: 13.02.2020
(51) Int. Cl.: H01L 31/0203, H01L 31/048, H02S 20/26

(54) **SOLAR CELL PANEL**

(30) Priority: 15.02.2019 KR 20190017830
(71) Applicant: LG Electronics Inc., Seoul 07336 (KR)
(72) Inventor: KIM, Chungyi, Seoul 06772 (KR); CHOI, Junghoon, Seoul 06772 (KR); KIM, Jeongkyu, Seoul 06772 (KR)
(74) Representative: Katérle, Axel
(86) International application number: PCT/KR2020/002052
(87) International publication number: WO 2020/166999

(57) **Abstract**

A solar cell panel according to an exemplary embodiment of the present disclosure comprises a first base member, an exterior forming portion formed on the first base member and made of an oxide ceramic composition, and a first cover member or glass substrate comprising a colored portion or cover portion.

## Description

### [Technical Field]

The present disclosure relates to a solar cell panel and, more particularly, to a solar cell panel with a building-integrated structure.

### [Background Art]

The compound semiconductor operates as a semiconductor by combining two or more elements rather than a single element such as silicon or germanium. Various types of compound semiconductors are developed and used in various fields.

Generally, a solar cell panel is installed on a rooftop or roof of a building when added to a building. In apartments or high-rise buildings, however, it was difficult to make efficient use of sunlight because solar cell panels are limited in size when installed on a rooftop or roof. In view of this, active research has been conducted in recent years on solar cell panels with a building-integrated structure that are installed on an outer wall, etc. of a house or building and integrated with the house or building. By applying a solar cell panel with a building-integrated structure, light-to-electricity conversion can occur across a wide area of an outer wall of the building, thereby ensuring the efficient use of sunlight.

By the way, the solar cell panel with the building-integrated structure needs to have a fine aesthetic appeal after installation, in order to be added to an outer wall of a building. Thus, there is a need to vary the color of the solar cell panel with the building-integrated structure or improve its exterior appearance. However, there are difficulties in improving the aesthetic appeal, exterior appearance, etc. of the existing solar cell panel with the building-integrated structure because solar cells, wires connected to the solar cells, etc. are seen from outside or the solar cell panels are available only in blue which is the color of the solar cells. Moreover, yellowing can occur when the solar cell panel is used for a long time, which may degrade the exterior appearance of the solar cell panel. In addition, if the solar cell panel with the building-integrated structure is installed on an outer wall - particularly a vertical wall - of a building, it becomes perpendicular to the floor, which could create glare on a glass substrate positioned on the front side of the solar cell panel with the building-integrated structure.

To prevent this, if the front side of the solar cell panel is colored to more than a certain thickness, the amount of light entering the solar cell panel is reduced, thus significantly reducing the power output of the solar cell panel. In another example, as disclosed in Japanese Patent Registration No. 3717369, the use of a colored film could make the color created by the colored film look different when viewed from the side or when it is bright, or make it look distinct from other members, which may degrade aesthetic appeal.

In the meantime, the solar cell panel with the building-integrated structure can be vulnerable to fire if a sheet of metal foil or resin is used for the rear side. To address this problem, a glass substrate was used for the rear side of the solar cell panel in order to increase fire resistance. However, in the conventional art, the glass substrate positioned on the rear side is used without any treatment, so that the solar cells or the wires connected to them are seen easily, which may impose limitations on enhancing the exterior appearance of the solar cell panel with the building-integrated structure.

### [Detailed Description of Invention]

### [Technical Problem]

The present disclosure provides a solar cell panel that has a good exterior appearance, prevents glare, and provides high power output.

More specifically, the present disclosure provides a solar cell panel with a front glass substrate, which is enhanced in exterior appearance due to the front glass substrate, prevents glare, and maintains high power output because of its high light transmittance.

Furthermore, the present disclosure provides a solar cell panel with a rear glass substrate, which is enhanced in exterior appearance by keeping solar cells from being seen on the solar cell panel.

### [Technical Solution]

An exemplary embodiment of the present disclosure provides a solar cell panel comprising: a first base member; an exterior forming portion formed on the first base member and made of an oxide ceramic composition; and a first cover member or glass substrate comprising a colored portion or cover portion. A first transmittance, which is the average light transmittance of the exterior forming portion in an infrared region, may be equal to or higher than a second transmittance, which is the average transmittance of the exterior forming portion in a visible region. The solar cell panel may further comprise: a solar cell; a sealing member for sealing the solar cell; and a second cover member or glass substrate. In this case, the first cover member may be disposed on the sealing member on one side of the solar cell, and the second cover member may be disposed on the sealing member on the other side of the solar cell.

More specifically, the exterior forming portion may be made of an oxide ceramic composition having an amorphous glass substrate.

In an example, in the exterior forming portion, the first transmittance may be higher than the second transmittance. Moreover, in the exterior forming portion, the first transmittance may be higher than the second transmittance by 2 % or more. In the exterior forming portion, a third transmittance, which is the average light transmittance in an ultraviolet region, may be lower than the first and second transmittances. Here, in the exterior forming portion, a first difference between the first average transmittance and the second average transmittance may be greater than a second difference between the second average transmittance and the third average transmittance.

The exterior forming portion may comprise voids to be porous. The voids may have a size of 0.1 um or more. Moreover, the surface roughness of the boundary between the first base member and the exterior forming portion, where the exterior forming portion is formed, may be higher than the surface roughness of the other part of the first base member where the exterior forming portion is not formed.

The exterior forming portion may have a higher refractive index than the first base member or the sealing member, and the exterior forming portion may have a thickness of 1 um or more.

The exterior forming portion may be formed on part of or the entire first base member, or the exterior forming portion may be formed on part of or an entire cover area where the exterior forming portion is seen as an integrated whole.

The first cover member, the first base member, or the glass substrate included therein may comprise a tempered or semi-tempered glass substrate. In this case, the exterior forming portion may comprise a ceramic frit as a primary material, and the exterior forming portion may be composed of an integrated portion which constitutes part of the tempered or semi-tempered glass substrate as the ceramic frit is mixed into the tempered or semi-tempered glass substrate. In an example, the first cover member may comprise a semi-tempered glass substrate having a surface compressive stress of 60 MPa or less.

Another exemplary embodiment of the present disclosure provides a solar cell panel in which, when the International Commission on Illumination (CIE) Lab (that is, CIE L^{∗}a^{∗}b^{∗}) color coordinates and D65 standard illuminant are used, the color difference (ΔE^{∗}ab) between a solar cell and a second cover member may be 11 or less. For example, the second cover member may comprise a second base member composed of a glass substrate and a cover portion positioned on the second base member, in an inactive area where at least the solar cell is not positioned. Here, the cover portion may comprise a plurality of cover layers made of an oxide ceramic composition or each comprising a dielectric material or insulating material. In an example, the cover portion may comprise a silicon layer containing silicon that constitutes a photoelectric conversion portion of the solar cell, and a dielectric layer or insulating layer disposed on the silicon layer and having the same material and stacked structure as an anti-reflection layer positioned on one side of the solar cell.

The above-described solar cell panel may have a building-integrated structure

### [Advantageous Effects]

According to these exemplary embodiments, in the exterior forming portion provided on the first cover member, the first transmittance, which is the average light transmittance in the infrared region, is equal to or higher than the second transmittance, which is the average light transmittance in the visible region. The exterior forming portion may be made of an oxide ceramic composition to effectively prevent glare which may occur when the first cover member comprises a glass substrate. Also, the second cover member may be colored by the cover portion so as to have a color that keeps the solar cell, interconnectors, etc. from being seen, thereby further improving the external appearance of the solar cell panel.

### [Description of Drawings]

FIG. 1 is a view schematically showing an example of a building to which a solar cell panel according to an exemplary embodiment of the present disclosure is applied.

FIG. 2 is an exploded perspective view schematically showing a solar cell panel according to an exemplary embodiment of the present disclosure.

FIG. 3 is a schematic cross-sectional view taken along the line III-III of FIG. 2.

FIG. 4 is a plan view schematically showing a first cover member and second cover member included in the solar cell panel shown in FIG. 2.

FIG. 5 is a flowchart showing an example of a method of making the first cover member included in the solar cell panel according to the exemplary embodiment of the present disclosure.

FIGS. 6A to 6D are cross-sectional views showing the steps of the method of making the first cover member shown in FIG. 5.

FIG. 7 is a graph showing the light transmittance vs. wavelength of the exterior forming portion included in the solar cell panel for different colors according to the exemplary embodiment of the present disclosure.

FIG. 8 is a graph showing the spectral response (SR) vs. wavelength of a monocrystal silicon-based solar cell.

FIG. 9 is a graph showing the quantum efficiency (QE) vs. wavelength of a monocrystal silicon-based solar cell .

FIG. 10 shows scanning electron micrographs of examples of the first cover member included in the solar cell panel according to the exemplary embodiment of the present disclosure.

FIG. 11 is a view schematically illustrating light diffusion in the exterior forming portion of the first cover member included in the solar cell panel according to this exemplary embodiment of the present disclosure.

FIG. 12 is a partial cross-sectional view showing various examples of a second cover member included in a solar cell panel according to another exemplary embodiment of the present disclosure.

FIG. 13 is a plan view showing an example of a first cover member included in a solar cell panel according to yet another exemplary embodiment of the present disclosure.

FIG. 14 is a cross-sectional view taken along the line A-A of FIG. 13.

FIG. 15 is a plan view showing various examples of a first cover member included in a solar cell panel according to a modification of the present disclosure.

FIG. 16 is a plan view showing an example of a second cover member included in a solar cell panel according to a further exemplary embodiment of the present disclosure.

FIG. 17 is a photograph of part of an example of a solar cell panel according to an exemplary embodiment of the present disclosure.

FIG. 18 is a plan view showing different examples of a second cover member included in a solar cell panel according to another modification of the present disclosure.

FIG. 19 is a plan view showing a first cover member included in a solar cell panel according to a further exemplary embodiment of the present disclosure.

FIG. 20 is a plan view showing a first cover member included in a solar cell panel according to a further exemplary embodiment of the present disclosure.

### [Mode for Invention]

Hereinafter, embodiments of the present disclosure will be described in detail with reference to the accompanying drawings. However, the present disclosure is not limited to these embodiments and various alterations thereof are possible.

In the drawings, parts not related to description are illustrated for clear and brief description of the present disclosure, and the same reference numerals are used throughout the specification to refer to the same or considerably similar parts. In addition, thicknesses, widths and the like are exaggerated or reduced in the drawings for clarity of description and thicknesses, widths and the like of the present disclosure are not limited to the illustration of the drawings.

In addition, throughout this specification, when one element is referred to as "comprising" another element, the term "comprising" specifies presence of another element but does not preclude presence of other additional elements, unless context clearly indicates otherwise. Additionally, when one element such as a layer, a film, a region, or a plate is referred to as being "on" another element, the one element may be directly on the another element, and one or more intervening elements may also be present. In contrast, when one element such as a layer, a film, a region or a plate is referred to as being "directly on" another element, one or more intervening elements are not present.

Hereinafter, a solar cell panel according to an exemplary embodiment of the present disclosure will be described in details with reference to the accompanying drawings.

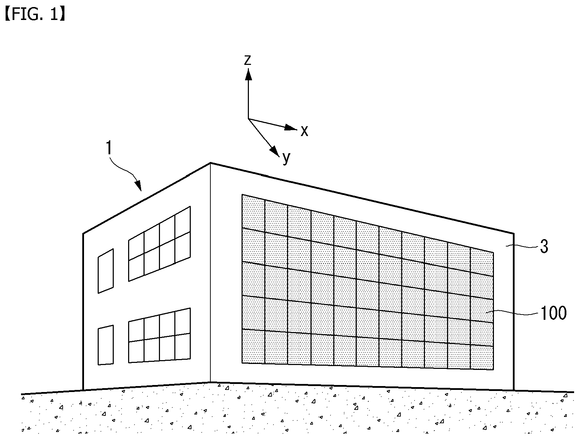

FIG. 1 is a view schematically showing an example of a building 1 to which a solar cell panel 100 according to an exemplary embodiment of the present disclosure is applied.

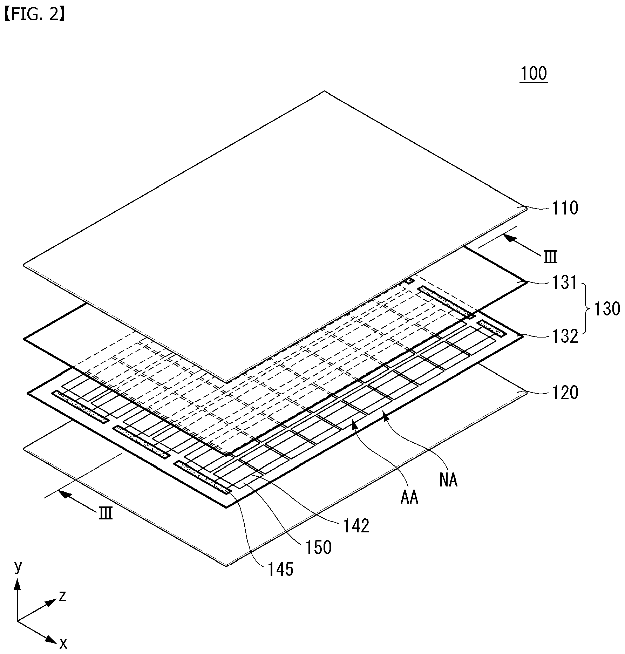

Referring to FIG. 1, the solar cell panel 100 according to this exemplary embodiment may be a solar cell panel with a building-integrated structure which is applied to, for example, an outer wall surface (e.g., a vertical wall 3, a roof surface, etc.) of the building 1. However, the present disclosure is not limited to this, but the solar cell panel 100 may be installed on the roof of the building 1 or in other places than the building 1. The solar cell panel 100 may comprise a solar cell (reference numeral 150 of FIG. 2) to generate electricity from sunlight.

In this exemplary embodiment, the solar cell panel 100 may have a certain color, image, pattern, feel, texture, etc. This certain color, image, pattern, feel, texture, etc. gives the building 1 a better aesthetic appeal and helps to reduce loss of sunlight, so as to minimize or prevent a decrease in sunlight conversion efficiency. Referring to FIGS. 2 to 4 in conjunction with FIG. 1, the solar cell panel 100 will be described in more details.

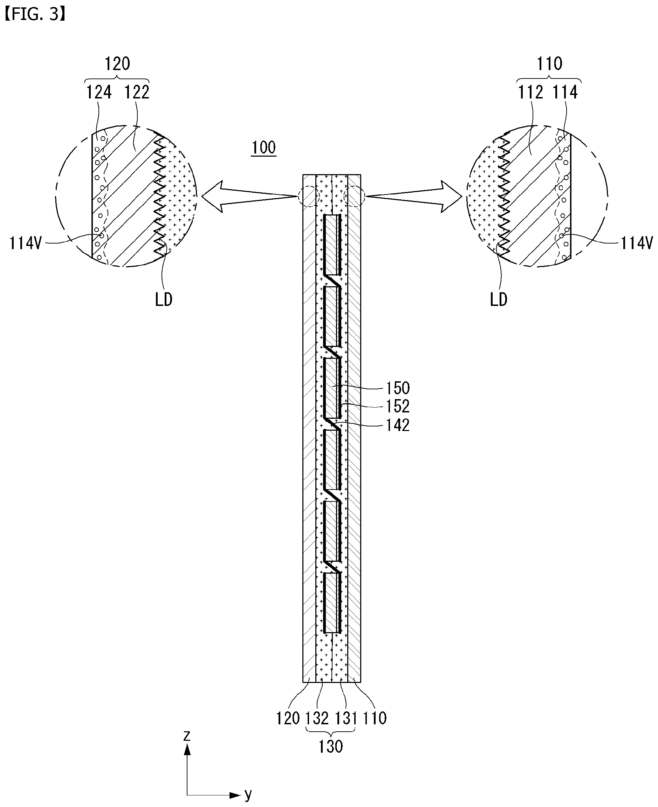

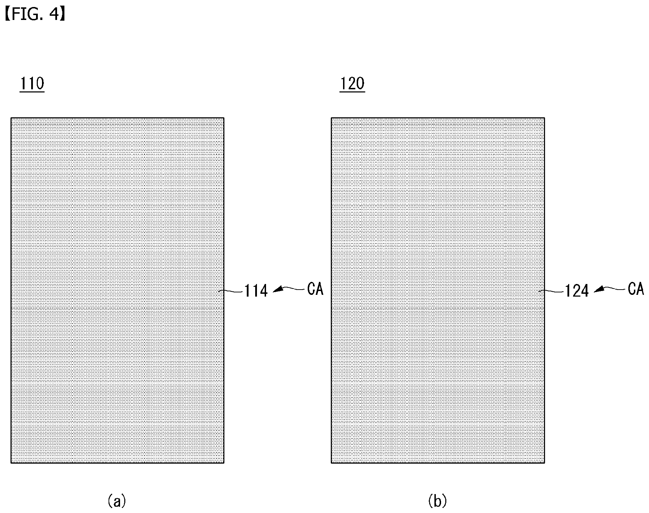

FIG. 2 is an exploded perspective view schematically showing a solar cell panel 100 according to an exemplary embodiment of the present disclosure. FIG. 3 is a schematic cross-sectional view taken along the line III-III of FIG. 2. FIG. 4 is a plan view schematically showing a first cover member 110 and second cover member 120 included in the solar cell panel 100 shown in FIG. 2. For a simplified and clear illustration, FIG. 2 illustrates the first cover member 110 and the second cover member 120 in a simplified way, but does not illustrate an exterior forming portion 114 and a cover member 124. Also, FIG. 3 does not give a detailed illustration of the structure of the solar cell 150, but schematically illustrates only an anti-reflective layer 152 formed on the front side.

Referring to FIGS. 2 to 4, the solar cell panel 100 according to this exemplary embodiment comprises a solar cell 150, a sealing member 130 for sealing the solar cell 150, a first cover member (or front member) 110 disposed on the sealing member 130 on one side (e.g., front) of the solar cell 150, and a second cover member (or rear member) 120 disposed on the sealing member 130 on the other side (e.g., rear) of the solar cell 150.

In this case, the solar cell 150 may comprise a light-to-electricity converter for converting solar energy into electrical energy and an electrode electrically connected to the light-to-electricity converter to collect and transfer current. For example, the solar cell 150 may be a solar cell that generate electrical energy from light having a wavelength range of at least 100 nm to 1,400 nm (for example, light of 100 nm to 1,200 nm). In this exemplary embodiment, for example, the light-to-electricity converter may comprise a crystalline silicone substrate (e.g., silicon wafer) and a dopant-containing conductive region or oxide-containing conductive region formed in or on the crystalline silicon substrate. The solar cell 150 has excellent electrical characteristics, based on a crystalline silicon substrate which has less defects because of its high crystallinity.

Also, in this exemplary embodiment, a plurality of solar cells 150 are spaced at intervals, and the plurality of solar cells 150 may be electrically connected in series, parallel, or in series-parallel by interconnectors 142 and 145. In an example, a plurality of solar cells 150 may be connected in series to form a string of solar cells extending in one direction. The interconnectors 142 and 145 may come in various structures and configurations, such as ribbons, wires, etc., that can connect the solar cells 150. In the present disclosure, the number, structure, configuration, etc. of the interconnectors 142 and 145 used for each solar cell 150 are not limited.

However, the present disclosure is not limited to this, and the structure, workings, etc. of the solar cell 150 may be variously modified. In an example, the solar cell 150 may come in various structures such as compound semiconductor solar cells, silicon semiconductor solar cells, and dye-sensitized solar cells. Also, only one solar cell 150 may be provided.

In this exemplary embodiment, an anti-reflective layer 152 is positioned on the front of the solar cell 150 to prevent light from entering. Destructive interference caused by the anti-reflective layer 152 may give the solar cell 150 a certain color (e.g., blue, black, etc.). The interconnectors 142 and 145 may be made of metal. Accordingly, if the first cover member 100 is composed only of a glass substrate, the boundary between an active area AA where the solar cell 150 is positioned and an inactive area NA where the solar cell 150 is not positioned, the interconnectors 142 and 145 positioned in the inactive area NA, and so on may be easily seen. This may degrade the aesthetic appeal of the solar cell panel 100. In view of this, in this exemplary embodiment, the first and second cover members 110 and 120 may include an exterior forming portion 114 or cover portion 124, which will be described later in details.

For example, the anti-reflective layer 152 of the solar cell 150 may have a stacked structure of multiple insulating layers containing a silicon-containing oxide, nitride, or carbide (e.g., silicon oxide, silicon nitride, or silicon carbide), silicate, or amorphous silicon. Alternatively, the anti-reflective layer 152 of the solar cell 150 may have a stacked structure of multiple insulating layers, each made of an oxide or oxynitride containing silicon, titanium, aluminum, zirconium, zinc, antimony, or copper. If the anti-reflective layer 152 is made of oxide or oxynitride, it further comprises a silicon nitride-containing layer and/or a silicon carbonitride-containing layer within or outside it to prevent problems caused by ultraviolet light, moisture, etc. However, the present disclosure is not limited to this, and the anti-reflective layer 152 may have various materials, stacked structures, and so on.

The first cover member 110 is positioned on the sealing member 130 (for example, a first sealing member 131) and forms one side (for example, the front) of the solar cell panel 100, and the second cover member 120 is positioned on the sealing member 130 (for example, a second sealing member 132) and forms the other side (for example, the rear) of the solar cell 150. The first cover member 110 and the second cover member 120 may be made of an insulating material that protects the solar cell 150 from external impacts, humidity, ultraviolet light, and so on. A concrete structure of the first and second cover members 110 and 120 will be described later in details.

The sealing member 130 may comprise first and second sealing members 131 and 132 respectively positioned on the front and rear of the solar cell 150. The first sealing member 131 and the second sealing member 132 prevent moisture and oxygen intrusion, and chemically bind the elements of the solar cell panel 100. The first and second sealing members 131 and 132 may be made of a transparent and adhesive insulating material. In an example, the first sealing member 131 and the second sealing member 132 may be made using ethylene-vinyl acetate (EVA) copolymer resin, polyvinyl butyral, silica resin, ester resin, olefin resin (e.g., polyolefin), etc. The solar cell 150, first sealing member 131, and first cover member 110, connected by the second cover member 120, second sealing member 132, and interconnectors 142 and 145 by a lamination process or the like using the first and second sealing members 131 and 132, may be integrated together to constitute the solar cell panel 100.

However, the present disclosure is not limited to this. Accordingly, the first and second sealing members 131 and 132 may comprise other various materials than those described above and have various configurations.

In this exemplary embodiment, the first and second cover members 110 and 120 may give the solar cell panel 100 a desired exterior appearance like a certain color, image, pattern, feel, and texture, or may have a certain structure for keeping the solar cell 150 or the interconnectors 142 and 145 connected to it from being clearly seen.

The first cover member 110 may be transmissive to allow light passes through it, so as not to block the light entering the solar cell 150. More specifically, the first cover member 110 may comprise a first base member 112 and an exterior forming portion 114 formed on the first base member 112 and made of an oxide ceramic composition to form a desired exterior. The exterior forming portion 114 may serve to give the solar cell panel 100 a desired external appearance and keep the solar cell 150 or the interconnectors 142 and 145 connected to it from being clearly seen.

The second cover member 120 may provide high fire resistance and insulation. More specifically, the second cover member 120 may comprise a second base member 122 and a cover portion 124 formed on the second base member 122. The cover portion 124 may serve to keep the solar cell 150 or the interconnectors 142 and 145 connected to it from being clearly seen.

The first base member 112 may be made of a material with high light transmittance (e.g., a transparent material). For example, the first base member 112 may be a substrate, film, sheet, or the like made of glass, resin (e.g., polycarbonate), etc. The first base member 112 may be made up of a single layer or multiple layers. The second base member 122 may be made of a material with high fire resistance and insulation. The second base member 122 may be a substrate, film, sheet, or the like made of glass, resin, etc.

Particularly, the first and second base members 112 and 122 may be composed of a glass substrate with high transparency, high insulation properties, stability, durability, and fire resistance. In an example, the first and second base members 112 and 122 may be a low-iron glass substrate (e.g., low-iron tempered glass substrate) with an 80 % (for example, 85 % or higher) or higher transmittance of light with a wavelength of 380 nm to 1,200 nm. The use of such a low-iron tempered glass substrate containing a low amount of iron may prevent sunlight reflection and increase sunlight transmittance. Also, the use of a low-iron tempered glass substrate allows for effective protection of the solar cell 150 against external impacts or the like.

In this case, in a case where the solar cell panel 100 is used as an exterior material of the building 1, the first or second cover 110 or 120 or the solar cell panel 100 require enough strength to withstand external impacts such as wind pressure, hail, and snow load. To this end, the first or second cover member 110 or 120 or the first or second base member 112 or 122 may have a deflection of 5 mm or less in the direction of applied force when a force of 2,400 Nm2 is applied. If the aforementioned deflection exceeds 5 mm, the durability against external impacts such as wind pressure, hail, and snow load is not enough to use the solar cell panel 100 as an exterior material of the building 1.

In an example, the first or second base member 112 or 122 may have a thickness of 2.8 mm or more, for example, from 2.8 mm to 12 mm (more specifically, from 2.8 mm to 8 mm) and an area of 0.04 to 10 m2. If the first or second base member 112 or 122 has a thickness of less than 2.8 mm, the solar cell panel 100 may not have enough durability to withstand external impacts or to be applied to the building 1. If the thickness of the first or second base member 112 or 122 exceeds 12 mm, the weight of the solar cell panel 100 may increase, making it difficult to apply the solar cell panel 100 to the building 1. The aforementioned area of the first or second base member 112 or 122 is limited to ensure the structural stability, productivity, etc. of the solar cell panel 100.

However, the present disclosure is not limited to this, and the defection, thickness, area, etc. of the first or second base member 112 or 122 may vary.

In this exemplary embodiment, the exterior forming portion 114 may be formed on the first base member 112. Here, the exterior forming portion 114 is a portion where the solar cell panel 100 is configured to have a desired color, image, pattern, feel, texture, etc. The exterior forming portion 114 may have a certain color, including achromatic colors such as white, gray, and black or chromatic colors such as red, yellow, green, blue, etc. Alternatively, the exterior forming portion 114 may exhibit transparent or semi-transparent characteristics, exhibit non-glossy or glossy characteristics, or have a different texture from the first base member 112, in order to prevent glare. The exterior forming portion 114 may serve to keep the solar cell 150 or the interconnectors 142 and 145 connected to it from being clearly seen from outside. The cover portion 124 may be formed on the second base member 122. The cover portion 124 may have a color that keeps the solar cell 150 or the interconnectors 142 and 145 connected to it from being clearly seen from outside.

In this exemplary embodiment, the exterior forming portion 114 and the cover portion 124 may be made of an oxide ceramic composition. Now, a detailed description will be given in detail below of the exterior forming portion 114 made of an oxide ceramic composition first and then of the cover portion 124.

In this exemplary embodiment, the exterior forming portion 114 may be made of an oxide ceramic composition. More specifically, the oxide ceramic composition of the exterior forming portion 114 may have an amorphous glass structure. For example, the exterior forming portion 114 may be made of a glassy oxide ceramic composition.

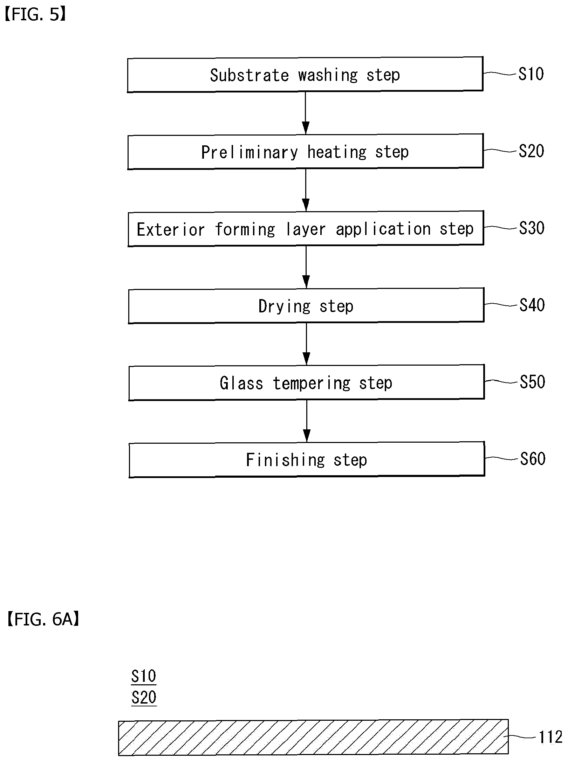

Referring to FIGS. 5 and 6A to 6D, a detailed description will be given below in conjunction with FIGS. 1 to 4 - first of a method of forming an exterior forming portion 114 made of an oxide ceramic composition with an amorphous glass structure on the first base member 112 as described above (i.e., a method of making the first cover member 110 having the exterior forming portion 114 according to this exemplary embodiment) and then of the exterior forming portion 114 made using this method).

FIG. 5 is a flowchart showing an example of a method of making the first cover member 110 included in the solar cell panel 100 according to the exemplary embodiment of the present disclosure. FIGS. 6A to 6D are cross-sectional views showing the steps of the method of making the first cover member 110 shown in FIG. 5.

Referring to FIG. 5, the method of making the first cover member 110 according to this exemplary embodiment may comprise a substrate washing step S10, a preliminary heating step S20, an exterior forming layer application step S30, a drying step S40, a glass tempering step S50, and a finishing step S60.

As shown in FIG. 6A, in the substrate washing step S10, a first base member 112 composed of a non-tempered glass substrate is washed and dried. The substrate washing step S10 allows for removal of foreign materials or oil film from the first base member 112.

The non-tempered glass substrate may have an 80 % or higher (e.g., 85 % or higher) transmittance of light with a wavelength of 380 nm to 1,200 nm and a thickness of 2.8 mm or more. In an example, the non-tempered glass substrate may be a non-tempered glass substrate for construction, and may be prepared by cutting, chamfering, or surface etching.

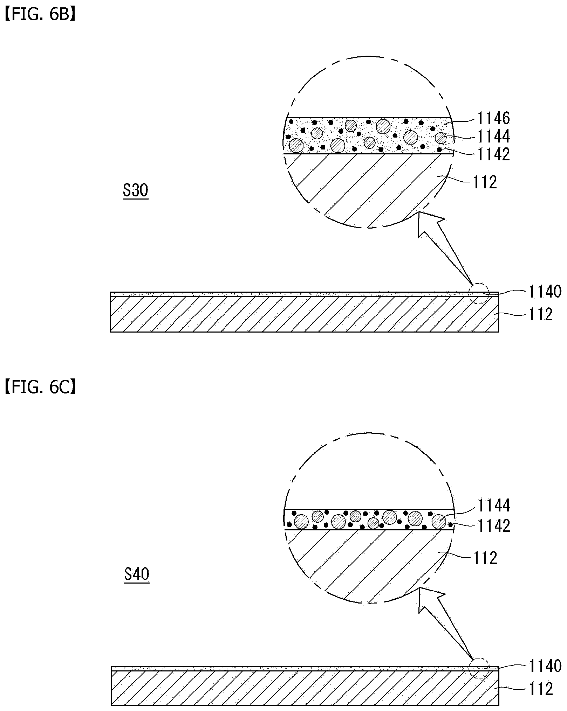

After the substrate washing step S10, the preliminary heating step S20 may be performed to preliminarily heat the first base member 112 at a temperature lower than in the drying step S40 or glass tempering step S50. In an example, the first base member 112 may be preliminarily heated at a temperature of 25 to 150 °C during a process in which the first base member 112 is fed to a device for the exterior forming layer application step S30. The preliminary heating may be performed by directly heating the first base member 112 or by using an infrared heater. By preliminarily heating the first base member 112, the exterior forming layer (reference numeral 1140 of FIG. 6B) comprising a ceramic frit (glass frit) (reference numeral 1144 of FIG. 6B) may be evenly applied in the exterior forming layer application step S30, and the adhesion of the exterior forming layer 1140 may be improved.

Next, as shown in FIG. 6B, in the exterior forming layer application step S30, a ceramic material layer (a ceramic ink, ceramic paste, or ceramic solution) comprising a ceramic frit 1144, a colorant 1142, and a resin 1146 is applied over the first base member 112 to form the exterior forming layer 1140. The ceramic material layer may further comprise an additive or the like. A variety of materials including oxides and metals may be used as the additive, depending on the properties desired. The additive may further comprise wax, water, oil, an organic solvent, or a diluent for adjusting viscosity.

Here, the ceramic frit 1144 primarily serves to stably attach the exterior forming portion 114 to the first base member 112 (particularly, glass substrate), and may optionally serve to embody a particular color, texture, feel, etc.

The ceramic frit 1144 is a compound containing a plurality of metals and a non-metal, which may comprise a plurality of metal compounds. The ceramic frit 1144 may be made of an oxygen polyhedron having a random network structure or glass structure containing a plurality of metals and oxygen. Once each of the plurality of metal compounds are composed of metal oxide, the random network structure or glass structure may be formed easily and stably. In this specification, if the ceramic frit 1144 may comprise a plurality of metal compounds (e.g., metal oxides), this means that the ceramic frit 1144 is made using a plurality of metal compounds (e.g., metal oxides) in such a way as to at least partially have a compound structure, random network structure, or glass structure containing a plurality of metals and a non-metal (e.g., oxygen).

The ceramic frit 1144 may comprise various well-known materials. For example, the ceramic frit 1144 may primarily comprise a silicon oxide SiOx (e.g., SiO2) and at least one among aluminum oxide AlOx (e.g., Al2O3), sodium oxide NaOx (e.g., Na2O), bismuth oxide BiOx (e.g., Bi2O3), boron oxide Box (e.g., B2O), and zinc oxide ZnOx (e.g., ZnO). Besides, the ceramic frit 1144 may further comprise aluminum oxide, sodium oxide, bismuth oxide, boron oxide, zinc oxide, titanium oxide TiOx (e.g., TiO2), zirconium oxide ZrOx (e.g., ZrO2), potassium oxide KOx (e.g., K2O), lithium oxide LiOx (e.g., Li2O), calcium oxide CaOx (e.g., CaO), cobalt oxide CoOx, and iron oxide FeOx. For example, the ceramic frit 1144 may be composed of a bismuth borosilicate ceramic material (e.g., a Bi2O3-Al2O-SiO2 material) comprising bismuth oxide, boron oxide, and silicon oxide. Alternatively, the ceramic frit 1144 may be composed of a NAOS ceramic material (e.g., a Na2O-Al2O3-SiO2 material) comprising sodium oxide, aluminum oxide, and silicon oxide. Alternatively, the ceramic frit 1144 may be composed of a ceramic material (e.g., ZnO-SiO2-B2O3 material) comprising zinc oxide, silicon oxide, and boron oxide. However, the present disclosure is not limited to this, and the ceramic frit 1144 may be composed of other various materials.

The colorant 1142 is added to give the exterior forming portion 114 a desired exterior appearance. For example, in a case where the exterior forming portion 114 has a certain color, a material for expressing a unique color by selectively absorbing or reflecting the visible rays of sunlight may be used as the colorant 1142. In an example, the colorant 1142 may be a pigment. The pigment refers to a colorant composed of an inorganic component that is not soluble in water and most organic solvents, which produces a color by coating the surface of the first base member 112. The pigment shows excellence in chemical resistance, light resistance, weatherability, and hiding power. That is, the pigment has resistance in alkalis and acids, is not easily discolored or faded from exposure to ultraviolet light, and is resistant to weather. For reference, if a dyestuff composed of an organic component soluble in organic solvents is used as the colorant, the molecular structure may be easily broken by sunlight, thus decreasing stability. Thus, a protection layer for protecting the dyestuff may be needed, which may make the manufacturing process complicated. For this reason, in this exemplary embodiment, the colorant 1142 may not comprise a pigment. However, the present disclosure is not limited to this, and the colorant 1142 may comprise a variety of materials such as a pigment.

The colorant 1142 may be composed of a material selected by taking into account the appearance of the exterior forming portion 114. Although, in the drawings, the colorant 1142 is provided separately from the ceramic frit 1144, the present disclosure is not limited to this. For example, the exterior forming portion 114 may have a desired appearance by the material of the ceramic frit 1144, and therefore the colorant 1142 may not be added separately from the ceramic frit 1144. Alternatively, the ceramic frit 1144 and the colorant 1142 may not be clearly distinguished from each other. In this exemplary embodiment, the metals in the material of the ceramic frit 1144 may substitute part of the metals in the random network structure or glass structure (e.g., an oxygen polyhedron) of the ceramic frit 1144 and be included in the corresponding structure. Alternatively, the metals in the colorant 1142 may be positioned at an interstitial site of the random network structure, glass structure, or oxygen polyhedron of the ceramic frit 1144.

For example, the exterior forming portion 114 may have a white color by a metal compound (e.g., metal oxide) contained in the ceramic frit 1144. In an example, if the ceramic frit 1144 comprises at least one selected from the group consisting of lead oxide PbOx (e.g., PbO), titanium oxide, aluminum oxide, and bismuth oxide, the exterior forming portion 114 may have a white color. When the exterior forming portion 114 has a white color, the ceramic frit 1144 may further comprise a material such as boron oxide, in addition to the aforementioned materials. In an example, when the exterior forming portion 114 has a white color, the ceramic frit 1144 may be composed of a ceramic material (e.g., a Bi2O3-SiOx-B2O material) comprising bismuth oxide, silicon oxide, and boron oxide, a ceramic material (PbOx-SiOx-B2O material) comprising lead oxide, silicon oxide, and boron oxide, a ceramic material (TiOx-SiOx-B2O material) comprising titanium oxide, silicon oxide, and boron oxide, or a ceramic material (AlOx-SiOx-B2O material) comprising aluminum oxide, silicon oxide, and boron oxide. However, the lead oxide may not be contained in the exterior forming portion 114 or ceramic frit 1144 according to this exemplary embodiment, because of environmental considerations.

In another example, a variety of colorants 1142 may be added in order for the exterior forming portion 114 to have a color other than white. That is, one or two or more materials corresponding to a desired color may be used as the colorant 1142. The material of the colorant 1142 may comprise a metal or a metal-containing oxide, carbide, nitride, sulfide, chloride, or silicate.

For example, in order to produce a red or yellow color, a material comprising at least one among copper (Cu), iron (Fe), nickel (Ni), chrome (Cr), uranium (U), and vanadium (V) may be used as the colorant 1142. In order to produce a green or blue color, a material comprising at least one among titanium (Ti), magnesium (Mg), and rutile may be used as the colorant 1142. Besides, the colorant 1142 may comprise cobalt oxide, iron oxide, copper oxide (CuOx), chrome oxide (CroOx), nickel oxide (NiOx), manganese oxide (MnOx), tin oxide (SnOx), antimony oxide (SbOx), and vanadium oxide (VOx).

As a more specific example, as the colorant 1142, CoAl2O4 may be used to produce cyan, Co2SiO4, etc. may be used to produce blue, Co2Cr2O4 may be used to produce green, Ti(Cr, Sb)O2 may be used to produce yellow, or CoFe2O4 or Co-Cr-Fe-Mn spinel may be used to produce black. Alternatively, as the colorant 1142, NiO, Cr2O3, etc. may be used to produce green, Cr-AI spinel, Ca-Sn-Si-Cr spin, Zr-Si-Fe zircon, etc. may be used to produce pink, or Sn-Sb-V rutile may be used to produce gray, Ti-Sb-Ni rutile, Zn-V baddeleyite, etc. may be used to produce yellow, Co-Zn-AI spinel may be used to produce blue, Zn-Fe-Cr spinel may be used to produce brown, or Ca-Cr-Si garnet may be used to produce green. Alternatively, as the colorant 1142, Co-Zn-Si willemite, Co-Si olivine, etc. may be used to produce dark blue, Zn-Fe-Cr-AI spinel, etc. may be used to produce brown, and Au, etc. may be used to produce magenta. These materials are merely one example, and the present disclosure is not limited thereto.

In the above description, it is exemplified that the exterior forming portion 114 has a certain color. However, the present disclosure is not limited thereto. Thus, the exterior forming portion 114 may be transparent or translucent (semi-transparent), may be glossy or non-glossy, express a specific texture, or prevent glare. In this instance, the exterior forming portion 114 may comprise the colorant 1142 or not. In this instance, in order for the exterior forming portion 114 not to have a white color, the ceramic frit 1144 may not comprise lead oxide, aluminum oxide, etc., which may exhibit white. In an example, if the exterior forming portion 114 is transparent or translucent, the ceramic frit 1144 may be composed of a ceramic material (NaOx-SiOx-B2O material) comprising sodium oxide, silicon oxide, and boron oxide. Although titanium oxide and bismuth oxide are materials that can be used to produce white, they may be partially included to keep the exterior forming portion 114 transparent or translucent. However, even if the exterior forming portion 114 is transparent or translucent, a small amount of pigment or colorant 1142 may be included to give a tint of color (for example, translucent with a tint of red, transparent with a tint of green, etc.).

The resin 1146 may be a substance used to give proper viscosity, fluidity, etc. when a ceramic material layer is applied and to uniformly mix the colorant 1142 and the ceramic frit 1144, which may be volatile or non-volatile. The resin 1146 may include a variety of well-known substances. For example, as the resin 1146, an organic resin such as an acrylic resin, a cellulose resin, or so on may be used, or an inorganic resin such as a silicone resin may be used.

The ceramic material layer or exterior forming layer 1140 comprises the ceramic frit 1144 in the largest amount. The amount of the colorant 1142, if added, may be smaller than the amount of the ceramic frit 1144. For example, if the colorant 1142 is added, the ceramic frit 1144 may be present in an amount from 40 to 90 parts by weight (for example, 50 to 90 parts by weight), out of 100 parts by weight of the ceramic material layer or exterior forming layer 1140, the colorant 1142 may be present in an amount from 5 to 50 parts by weight, and the resin 1146 and/or an additive may be present in an amount from 0 to 20 parts by weight. If the colorant 1142 is not added, the ceramic frit 1144 may be present in an amount from 50 to 100 parts by weight (for example, 60 to 100 parts by weight), out of 100 parts by weight of the ceramic material layer or exterior forming layer 1140, and the resin 1146 and/or an additive may be present in an amount from 0 to 50 parts by weight (for example, 0 to 40 parts by weight). However, the present disclosure is not limited thereto, and the ceramic material layer or exterior forming layer 1140 may have various compositions.

The exterior forming layer 1140 may be applied to the first base member 112 by a spraying process, a printing process, or a sol-gel process. For example, the printing process may be inkjet printing (for example, digital inkjet printing), lithography printing, a laser printing process, screen printing, or the like. According to the printing process, the exterior forming layer 1140 can be stably formed with a desired thickness by a simple process. However, the present disclosure is not limited thereto, and the exterior forming layer 1140 may be applied by various other methods.

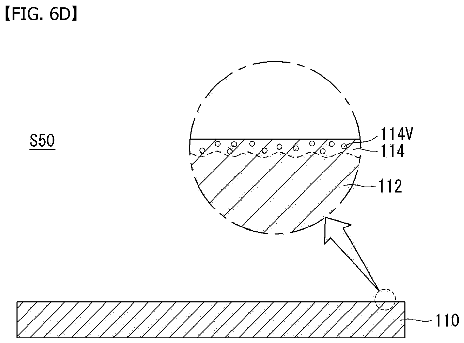

Next, as shown in FIG. 6C, in the drying step S40, heat is applied to volatilize the resin 1146 while drying the exterior forming layer 1140. The resin 1146 or the like is first volatilized so that the colorant 1142, the ceramic frit 1144, etc. can be effectively mixed together with the first base member 112. In the drying step S40, the resin 1146 may be entirely removed, or part of it may remain. In this instance, voids (bubbles or the like) 114V (see FIG. 6D) composed of empty spaces may remain in at least part of where the resin 1146 is removed. For example, in the drying step S40, the exterior forming layer or 1140 may be dried at a temperature of 50 to 200° C. The drying step S40 may be carried out using an infrared heater, ultraviolet curing, or the like. However, the present disclosure is not limited thereto, and the drying temperature, the drying method, etc. may be variously changed.

Next, as shown in FIG. 6D, in the glass tempering step S50, a non-tempered glass substrate constituting the first base member 112 is tempered or semi-tempered by a heat tempering process through heat treatment or annealing. In this instance, the ceramic frit 1144, the colorant 1142, and the like included in the exterior forming layer 1140 are mixed into the tempered or semi-tempered glass substrate to attain phase equilibrium, thereby form the exterior forming portion 114 which constitutes part of the tempered or semi-tempered glass substrate. In this instance, the exterior forming layer 1140 may have a higher specific gravity than the first base member 112 because of its high mass ratio. If so, the exterior forming layer 1140 gets sticky and fused due to the high temperature in the glass tempering step S50, and therefore may be more easily mixed into the first base member 112 composed of a glass substrate.

The glass tempering step S50 may be performed at a temperature where the non-tempered glass substrate can be tempered or semi-tempered. For example, a heat treatment temperature for the glass tempering step S50 may be 500 to 800° C. (for example, 500 to 750° C or 650 to 750° C.), and heat treatment may be performed without high-pressure treatment (e.g., at near ambient pressure). However, the present disclosure is not limited to the temperature for the glass tempering step S50.

As an example, the non-tempered glass substrate constituting the first base member 112 may be semi-tempered in the glass tempering step S50. Accordingly, the first base member 112 or the first cover member 110 may be composed of a heat-strengthened and semi-tempered glass substrate. As such, the light transmittance of the first cover member 110 may be kept high. In this instance, the first cover member 110 made of semi-tempered glass may have a surface compressive stress of 60 MPa or less (for example, 24 to 52 MPa). As an example, the first cover member 110 may have an edge stress of about 30 to 40 MPa. That is, the semi-tempered glass may be formed by annealing it at a temperature slightly lower than a softening point and then slowly cooling it. For reference, fully tempered glass may be formed by a heat treatment at a temperature higher than a softening point and then quenching, and may have a surface compressive stress of 70 to 200 MPa.

As described above, in this exemplary embodiment, the light transmittance of the exterior forming portion 114 can be kept high by adjusting the heat treatment temperature, cooling rate, etc. in the glass tempering step S50. In particular, by keeping the heat treatment temperature within a predetermined range and keeping the cooling rate below a certain level, the exterior forming portion 114 may have an amorphous glass structure, so that the average light transmittance of light in an infrared region can be maintained relatively high. This will be described in more detail later. In contrast to this, if the heat treatment temperature is not maintained within a certain range and/or the cooling rate or pressure is too high, a phase change of the amorphous glass structure or an interfacial bond change between the glass substrate and the exterior forming portion may occur due to a change in the chemical structure of the oxide ceramic composition of the exterior forming portion. Thus, it might be difficult to keep the average light transmittance of light in the infrared region at a higher level than the average light transmittance of light in a visible region. Also, if the heat treatment temperature is lower than a certain level (for example, less than 650° C.), the exterior forming portion 114 is more highly likely to be peeled off from the first base member 112. If the heat treatment temperature exceeds a certain level (for example, exceeds 750° C.), the exterior forming portion 114 may not have desirable properties - for example, the exterior forming portion 114 may not have a desired color or the light transmittance tendency may change.

Next, in the finishing step S60, the first cover member 110 on which the glass tempering step S50 has been performed is cleaned and dried. Then, the manufacturing of the first cover member 110 having the integrated exterior forming portion 114 is completed.

In this instance, the content of sodium or potassium in the ceramic material layer, the exterior forming layer 1140, or the exterior forming portion 114 may be similar to or lower than the content of sodium or potassium in the first base member 112. Particularly, the content of sodium and potassium in the ceramic material layer, the exterior forming layer 1140, or the exterior forming portion 114 may be lower than the content of sodium and potassium in the first base member 112. As an example, the number of atoms of sodium or potassium contained in the ceramic material layer, the exterior forming layer 1140, or the exterior forming portion 114 may be 10x1018 atoms/cc or less. On the contrary, if the number of atoms of sodium or potassium contained in the ceramic material layer, the exterior forming layer 1140, or the exterior forming portion 114 exceeds 10×1018 atoms/cc, a potential-induced degradation (PID) due to a leakage current may occur, lowering the reliability of the solar cell panel 100. Also, the ceramic material layer, the exterior forming layer 1140, or the exterior forming portion 114 may not contain lead and/or chrome (for example, lead oxide and/or chromium oxide), so as to avoid environmental problems. For example, the amount of sodium, potassium, or lead contained in the ceramic material layer, the exterior forming layer 1140, or the exterior forming portion 114 may be measured or determined by secondary ion mass spectrometry (SIMS).

The first cover member 110 formed by the above manufacturing process comprises a first base member 112 composed of a tempered or semi-tempered glass substrate, and an exterior forming portion 114 comprising a ceramic frit 1144 in the tempered or semi-tempered glass substrate and composed of an integrated portion constituting part of the semi-tempered glass substrate. That is, the exterior forming portion 114 may be composed of part of the tempered or semi-tempered glass substrate constituting the first base member 112, and may comprise a material (e.g., a ceramic oxide composition having an amorphous glass structure) different from that of the first base member 112. The exterior forming portion 114 may be formed in such a manner that the ceramic frit 1144, the colorant 1142, etc. is diffused and penetrated into the first base member 112 and mixed with the material of the glass substrate, in a process of tempering or semi-tempering the glass substrate constituting the first base member 112. As such, the exterior forming portion 114 may be integrated with the first base member 112, thereby achieving excellence in physical durability and chemical durability.

In this exemplary embodiment, the exterior forming portion 114 is made of an oxide ceramic composition having an amorphous glass structure as described above. For example, the exterior forming portion 114 may comprise a plurality of metal compounds (for example, metal oxides) comprising a plurality of metals and a non-metal (e.g., oxygen) contained in the ceramic frit 1144 and/or the colorant 1142. Thus, the exterior forming portion 114 may have an oxygen polyhedron having a random network structure, glass structure, or random network structure comprising a plurality of metals and oxygen. Whether the exterior forming portion 114 is made of an oxide ceramic composition or not may be determined by X-ray photoelectron spectroscopy (XPS) or the like.

The oxide ceramic composition having the amorphous glass structure may be formed by heat treatment at a temperature lower than the temperature at which general oxide ceramic is formed. That is, the oxide ceramic composition having an amorphous glass structure may not comprise a crystalline portion or may only partially comprise a crystalline portion. In this instance, in the oxide ceramic composition having the amorphous glass structure, the amount of the amorphous portion may be equal to or larger than that of the crystalline portion - in particular, the amount of the amorphous portion may be larger than that of the crystalline portion. For example, an oxide ceramic composition having an amorphous glass structure may have a crystallinity of 50% or less (more specifically, less than 50%, for example, 20% or less). For reference, the conventionally-used, general oxide ceramic is an ionic bonded oxide, a covalent bonded oxide, or a combination thereof, which means an inorganic non-metal material produced at high temperature and high pressure. Most parts of this oxide ceramic may be crystallized because it is thermally treated at a high temperature of 850° C. or higher (for example, around 1400° C.) and at a high pressure.

The exterior forming portion 114 may comprise the ceramic frit 1144 as a base material (for example, a material present in the largest amount or a material present in an amount of 50 parts by weight or more). The exterior forming portion 114 may further optionally comprise a colorant 1142, an additive, or the like. Since the resin 1146 may be volatilized during the heat treatment in the glass tempering step S50, the exterior forming portion 114 may comprise the resin 1146 or not. The ceramic frit 1144 and the colorant 1142 of the exterior forming portion 114 may not be clearly distinguished from each other even when the exterior forming portion 114 comprises the colorant 1142. For example, a metal in a material included as the colorant 1142 may be present in the form of a metal contained in the oxygen polyhedron, glass structure, or random network structure constituting the ceramic frit 1144. The ceramic frit 1144, etc. included in the exterior forming portion 114 may be distinguished by various component analysis methods (for example, scanning electron microscopy-energy dispersive spectroscopy (SEM-EDX) or the like).

The first cover member 110 according to this exemplary embodiment may have a desired appearance by the exterior forming portion 114. For example, the appearance and light transmittance of the first cover member 110 may be adjusted by adjusting the color, material, area ratio, thickness, etc. of the exterior forming portion 114, or the material, size, concentration, density, etc. of the ceramic frit 1144, colorant 1142, etc. included in the exterior forming portion 114. In this exemplary embodiment, the exterior forming portion 114 has a lower light transmittance than the first base member 112 and therefore allows for transmission of part of sunlight. Then, the sunlight also may be transmitted through the exterior forming portion 114, and thus, a light loss due to the exterior forming portion 114 may be prevented or minimized. For example, the exterior forming portion 114 or the first cover member 110 having the exterior forming portion 114 may have a light transmittance of 10% or more (for example, 10% to 95%, more specifically, 20% to 95%) for light having a wavelength of 380 nm to 1,200 nm. However, the present disclosure is not limited thereto. Accordingly, the light transmittance may vary depending on the color, material, area, etc. of the exterior forming portion 114.

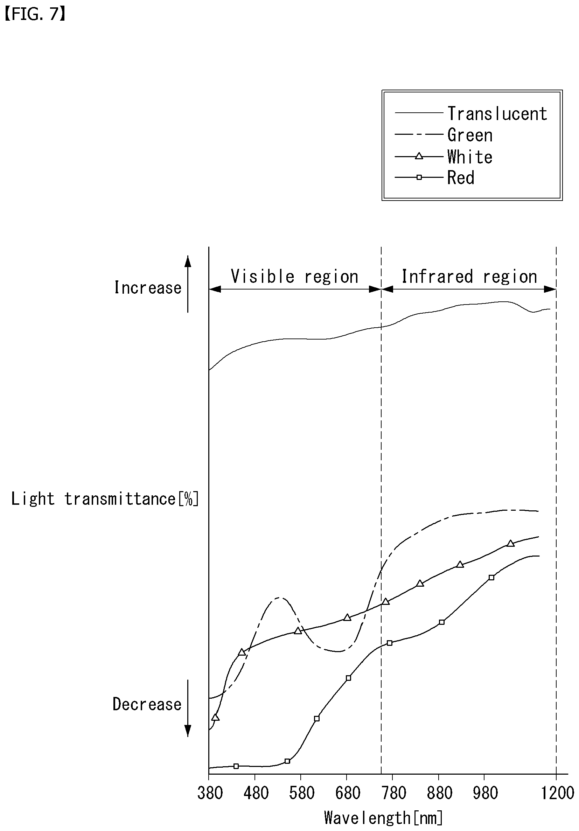

The exterior forming portion 114 according to this exemplary embodiment may be made of an oxide ceramic composition (particularly, an oxide ceramic composition having an amorphous glass structure) and have a specific light transmittance depending on wavelength, voids 114V, surface roughness, etc. Thus, a reduction in the power output of the solar cell panel 100 can be prevented or minimized even if the light transmittance is lowered by the exterior forming portion 114 to some degree. This will be described in detail with reference to FIGS. 7 to 11 in conjunction with FIG. 3.

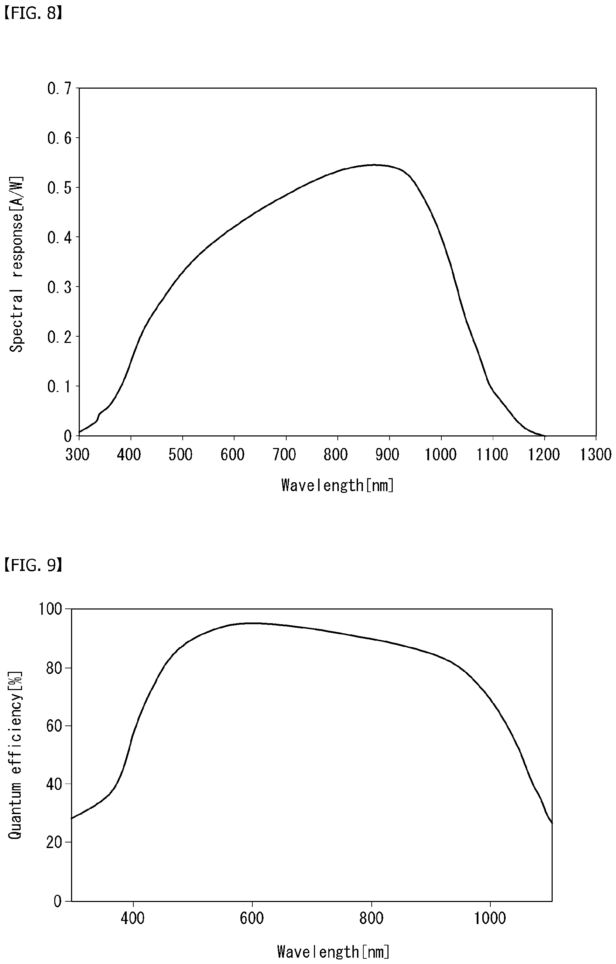

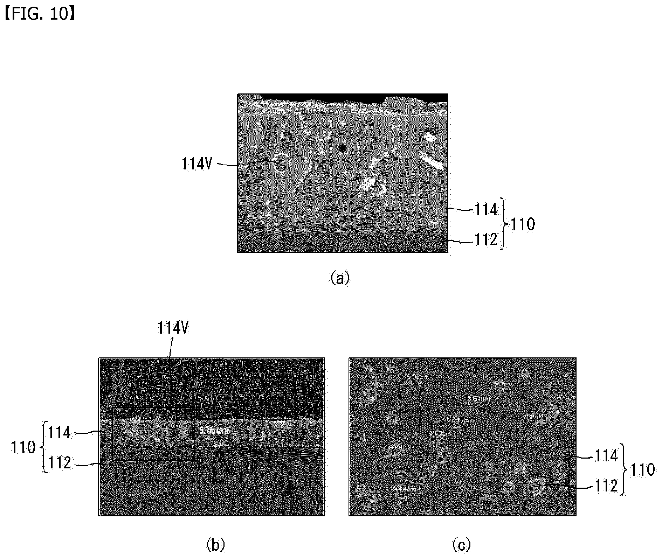

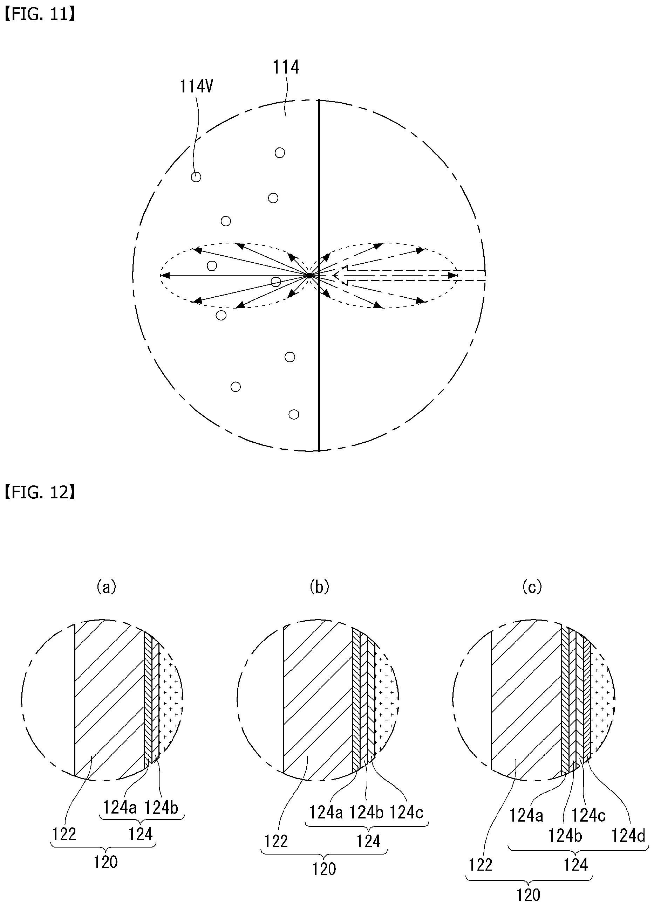

FIG. 7 is a graph showing the light transmittance of the exterior forming portion 114 included in the solar cell panel 100 vs. wavelength for different colors according to the exemplary embodiment of the present disclosure. FIG. 8 is a graph showing the spectral response vs. wavelength of a monocrystal silicon-based solar cell 150. FIG. 9 is a graph showing the quantum efficiency vs. wavelength of a monocrystal silicon-based solar cell 150. FIG. 10 shows scanning electron micrographs of examples of the first cover member 110 included in the solar cell panel 100 according to the exemplary embodiment of the present disclosure. FIG. 11 is a view schematically illustrating light diffusion in the exterior forming portion of the first cover member included in the solar cell panel according to this exemplary embodiment of the present disclosure.

In this exemplary embodiment, as shown in FIG. 7, in the exterior forming portion 114 made of an oxide ceramic composition having an amorphous glass structure, a first transmittance, which is the average light transmittance in the infrared region, may be equal to or higher than a second transmittance, which is the average transmittance in the visible region. In particular, in the exterior forming portion 114 made of an oxide ceramic composition having an amorphous glass structure, the first average transmittance may be greater than the second average transmittance. In the exterior forming portion 114 made of an oxide ceramic composition having an amorphous glass structure, a third transmittance, which is the average light transmittance in an ultraviolet region may be lower than the first and second transmittances, which are the average light transmittance in the infrared light region and the average light transmittance in the visible region, respectively. In this instance, the light in the ultraviolet region may be defined as light having a wavelength of 100 nm to 380 nm, the light in the visible light region may be defined as light having a wavelength of 380 nm to 760 nm, and light in the infrared region may be defined as light having a wavelength of 760 nm to 1,200 nm. The average light transmittance may be defined as the average of normalized light transmittance so as not to reflect the light transmittance of the first base member 112.

As shown in FIG. 7, it can be seen that the second average transmittance is higher than the third average transmittance, and that the first average transmittance is equal to or higher than the second average transmittance, though there may be variations depending on the color. This tendency can be realized by the heat treatment temperature, cooling rate, etc. in the glass tempering step S50.

If the first average transmittance is equal to or higher than the second average transmittance as described above, even if the exterior forming portion 114 is provided, the amount of light in the infrared region, out of the light passing through the first cover member 110 and reaching the solar cell 150, may be equal to or larger than the amount of light in the visible region. Accordingly, even when the light transmittance is lowered by the exterior forming portion 114 to some degree, a large amount of light in the infrared region reaches the solar cell 150 and therefore can be effectively used. Therefore, even if the light transmittance is lowered by the exterior forming portion 114 to some degree, a reduction in the photoelectric conversion efficiency of the solar cell 150 or the power output of the solar cell panel 100 can be prevented or minimized.

As described above, the first and second average transmittances may be greater than the third average transmittance. In this instance, the exterior forming portion 114 comprises the ceramic frit 1144, the colorant 1142, additive, etc. and therefore has a higher refractive index than the first base member 112 composed of a glass substrate and has a higher absorption coefficient than the first base member 112 composed of a glass substrate depending on the material. The light in the ultraviolet region does not contribute much to the photoelectric conversion efficiency of the solar cell 150 and the power output of the solar cell panel 100, and may induce a deformation, property change, etc. of the solar cell 150 and sealing member 130 due to its high photon energy. In this exemplary embodiment, the exterior forming portion 114 scatters, blocks, or absorbs light in the ultraviolet region, thereby lowering the light transmittance of light in the ultraviolet region. Accordingly, the photoelectric conversion efficiency of the solar cell 150 and the power output of the solar cell panel 100 are not affected much while the deformation, property change, etc. of the solar cell 150, sealing member 130, etc. that may be caused by ultraviolet light can be minimized.

For example, in this exemplary embodiment, in the exterior forming portion 114, the first transmittance may be higher than the second transmittance by 2 % or more. Alternatively, a first difference between the first average transmittance and the second average transmittance may be greater than a second difference between the second average transmittance and the third average transmittance. In this case, the light in the infrared region can be more effectively used in the solar cell panel 100. The above-described light transmittance may be measured by various methods - for example, both the transmittance (normal transmittance) of vertical light and the transmittance (diffused transmittance) of scattered light may be measured. For example, light transmittance may be measured by a standard measurement method such as ISO 9050:2003, BS EN 14500:2008, etc.

Referring to FIG. 8, it can be seen that the monocrystal silicon-based solar cell 150 has a high spectral response (that is, current density (Isc) or power output of a short-circuit current generated at a specific wavelength of light) to light in the infrared region. Referring to FIG. 9, it can be seen that the monocrystal silicon-based solar cell 150 has a high quantum efficiency for light in the infrared region. In this exemplary embodiment, by improving the average light transmittance in the infrared region having a high spectral response and a high quantum efficiency, the light in the infrared region can be effectively used even when the light transmittance is lowered to some degree by the exterior forming portion 114 which creates a specific color, feel, texture, or so on. Accordingly, even when the exterior forming portion 114 is formed, the photoelectric conversion efficiency of the solar cell 150 or the power output of the solar cell panel 100 can be kept high. Since the spectral response and quantum efficiency are very low in the ultraviolet region, even when the third transmittance of the exterior forming portion 114 is low, the photoelectric conversion efficiency of the solar cell 150 or the output of the solar cell panel 100 may be not affected by the low light transmittance.

In this exemplary embodiment, the exterior forming portion 114 may comprise voids 114V to be porous. The resin 1146 provided in the ceramic material layer or exterior forming layer 1140 may volatilize in a heat treatment process (for example, the glass tempering step S50) for forming the exterior forming portion 114, leaving the voids 114V in that portion.

As an example, voids 114V having a size of 0.1 um or more may be provided. It is possible to maximize the effect of the voids 114V when the voids 114V have the above size. The size of the voids 114V may vary depending on the method of forming the exterior forming portion 114. For example, the exterior forming portion 114 formed by inkjet printing may have voids 114V having a size of 0.1 um or more, and the exterior forming portion 114 formed by screen printing may have voids 114V having a size of 0.5 um or more. The maximum size of the voids 114V may be correspond to the thickness of the exterior forming portion 114. For example, the voids 114V may have a size of 0.1 to 15 um. More specifically, the voids 114V in the exterior forming portion 114 formed by inkjet printing may have a size of 0.1 to 7 um, and the voids 114V in the exterior forming portion 114 formed by screen printing may have a size of 0.5 um to 15 um. For example, the voids 114V may cover 4% or more of the total area in a plan view. In an example, the total area of the voids 114V formed by inject printing may be 4% or more of the exterior forming portion 114, and the total area of the voids 114V formed by screen printing may be 7.5% or more of the exterior forming portion 114.

The size, area ratio, etc. of the voids 114V may vary depending on the material of the ceramic material layer, exterior forming layer 1140, or exterior forming portion 114 (or the colorant 1142, ceramic frit 1144, resin 1146, etc. contained in it), the manufacturing method, process condition, etc. of the ceramic material layer, exterior forming layer 1140, or exterior forming portion 114. (a) of FIG. 10 shows a cross-sectional photograph of the first cover member 110 having the exterior forming portion 114 formed by inkjet printing, and (b) and (c) of FIG. 10 show cross-sectional and planar photographs of the first cover member 110 having the exterior forming portion 114 formed by screen printing. As shown in FIG. 10, voids 114V of a certain size or bigger are distributed throughout the exterior forming portion 114.

When the voids 114V are present in the exterior forming portion 114, light entering the solar cell panel 100 is dispersed and diffused widely at the voids 114V as shown in FIG. 11. More specifically, when the exterior forming portion 114 has the voids 114V, normal transmission and diffused transmission occur simultaneously, resulting in a hemispherical transmission. In this instance, as indicated by the solid line in FIG. 11, the voids 114V of the exterior forming portion 114 may scatter light so that the light is hemispherically transmitted to enter the solar cell panel 100. Then, part of the light directed toward the space between the solar cells 150 that may be lost may be directed toward the solar cell 150 and used, or may be re-used by scattering it at the interface between the exterior forming portion 114 and the first base member 112. Accordingly, even when the exterior forming portion 114 is provided, the photoelectric conversion efficiency of the solar cell 150 and the power output of the solar cell panel 100 can be kept high by maximizing the amount of light used for photoelectric conversion. For example, at least part of the exterior forming portion 114 may be positioned to correspond to the space between the solar cells 150. As indicated by the one-dot chain line in FIG. 11, the voids 114V of the exterior forming portion 114 scatters light so that the light is hemispherically transmitted toward the outside of the solar cell panel 100, thereby providing better anti-glare properties. On the other hand, if the exterior forming portion 114 has no voids 114V, there is no sufficient diffused transmission as compared with the exterior forming portion 114 having the voids 114V, giving it a relatively low light transmittance.

In this exemplary embodiment, the surface roughness of the boundary between the first base member 112 and the exterior forming portion 114 (that is, an interface at the exterior forming portion 114), where the exterior forming portion 114 is formed, may be higher than the surface roughness of the other part of the first base member 112 where the exterior forming portion 114 is not formed. That is, as indicated by the expanded circle in FIG. 3, the surface roughness of the boundary between the exterior forming portion 114 and one side of the first base member 112 of the first cover member 110 may be higher than the surface roughness of the other side of the first base member 112 or a lateral side thereof. The surface roughness may be relatively large at the interface with the first base member 112 when the exterior forming portion 114 is formed, because the ceramic frit 1144, colorant 1142, etc. may be mixed into the first base member 112 or a material or the like may move for phase equilibrium.

In FIG. 3, for example, it is shown that a light diffusion portion LD is positioned on the other side where the exterior forming portion 114 is not formed. The light diffusion portion LD can diffuse light to keep the solar cell 150 and the like from being seen as much as possible and improve the integrity of the color of the exterior forming portion 114. For example, when the light diffusion portion LD is formed to come into contact with the sealing member 130, the area of adhesion to the sealing member 130 can be increased to improve adhesion. For example, the light diffusion portion LD may have a size of 10 to 500 um, and may have various shapes such as a rounded shape (for example, a shape corresponding to part of a sphere), an angular shape, a pyramid shape, and so on. The above-described light diffusion portion LD may protrude in an embossed pattern or be depressed in an incised pattern.

In this instance, the size of the light diffusion portion LD may be equal to or larger than (for example, larger than) the surface roughness of the boundary where the exterior forming portion 114 is formed. In this instance, the size of the light diffusion portion LD may refer to a distance between the uppermost end and lowermost end of the light diffusion portion LD. Thus, the effect of diffusion by the light diffusion portion LD can be improved. The surface roughness of the boundary where the exterior forming portion 114 is formed may be equal to or higher than (for example, higher than) the surface roughness of the light diffusion portion LD. In this instance, the surface roughness of the light diffusion portion LD may refer to the surface roughness at an outer surface constituting the shape of the light diffusion portion LD. The surface roughness of the outer surface of the light diffusion portion LD may be relatively small because the light diffusion portion LD is formed through a specific processing process so as to have a certain shape.

Moreover, FIG. 3, etc. illustrates that the outer surface of the exterior forming portion 114 is flat, the present disclosure is not limited thereto. The outer surface of the exterior forming portion 114 may have irregularities, bends, etc. so as to correspond to irregularities, bends, etc. on the boundary between the exterior forming portion 114 and the first base member 112, and the surface roughness of the outer surface of the exterior forming portion 114 may be the same as or similar to the surface roughness of the boundary between the exterior forming portion 114 and the first base member 112, and therefore may be higher than the surface roughness of other parts of the first base member 112.

Due to the high surface roughness at the interface of the exterior forming portion 114, the exterior forming portion 114 can effectively scatter light. That is, once the voids 114V are formed in the exterior forming portion 114 and at the same time a high surface roughness is achieved at the interface of the exterior forming portion 114, light can be scattered effectively. Particularly, if the exterior forming portion 114 is positioned in a portion (that is, an inactive area NA) corresponding to the space between the solar cells 150, the light scattered by the exterior forming portion 114 may be directed toward the solar cell 150 and thus can be used for photoelectric conversion. Accordingly, the photoelectric conversion efficiency of the solar cell 150 and the power output of the solar cell panel 100 can be kept high.

The above-described exterior forming portion 114 may have a higher refractive index (for example, a refractive index of 1.48 or more) than the first base member 112 or the sealing member 130. The exterior forming portion 114 may have a thickness of 1 um or more (e.g., 1 um to 15 um). The thickness of the exterior forming portion 114 may vary depending on the manufacturing process of the exterior forming portion 114. For example, if the exterior forming portion 114 is formed by screen printing, it may have a thickness of 1 to 15 µm. If the exterior forming portion 114 is formed by inkjet printing, it may have a thickness of 1 um to 7 um. If the thickness of the exterior forming portion 114 is less than 1 µm, it may be difficult to create a desired appearance, and, if the colorant 1142 is added, it may be difficult to create a desired color because the density of the colorant 1142 is lowered. If the thickness of the exterior forming portion 114 exceeds 15 µm, the light transmittance may be lowered overall and the exterior forming portion 114 may be peeled off, crack, etc. For example, in order to simplify the manufacturing process of the exterior forming portion 114 and reduce the material cost, the thickness of the exterior forming portion 114 may be 1 um to 3 um (for example, 1 µm to 2 µm), but the present disclosure is not limited thereto. In addition, the thickness of the exterior forming portion 114 may be adjusted according to color. For example, if the exterior forming portion 114 has a white color having a relatively low light transmittance, the thickness of the exterior forming portion 114 may be smaller than that of the exterior forming portion 114 having other colors.

On the other hand, in the convention art, a layer formed on the first cover member 110 has a low light transmittance in the infrared region, and thus, the amount of light reaching the solar cell in the infrared region is smaller than the amount of light reaching the solar cell in the visible region. Thus, it has been difficult to effectively use the light in the infrared region. For example, an anti-reflection layer for preventing reflection has the largest light transmittance at a short wavelength of about 600 nm, which has the strongest solar light intensity, to prevent reflection of light of the short wavelength. In the conventional art, even if a layer (for example, an anti-reflection layer) provided on the first cover member 110 is formed of a material the same as or similar to that of the exterior forming portion 114, the average light transmittance in the infrared region is smaller than the average light transmittance in the visible light region unless the layer does has a ceramic structure. Also, the anti-reflection layer has a refractive index of about 1.3 which is smaller than those of the first base member 112 and sealing member 130 and has a thickness of 500 nm or less (e.g., around 200 nm). Accordingly, the anti-reflection layer has different properties from the exterior forming layer 1140 of this exemplary embodiment, and it is difficult to effectively use the light in the infrared region by the anti-reflection layer. Further, in most cases, since the layer (for example, the anti-reflection layer) provided on the first cover member 110 is formed by being laminated or deposited on the first cover member 112, the surface roughness at an interface of the layer (for example, the anti-reflection layer) provided on the first cover member 110 does not differ from those of the other portions.

In this exemplary embodiment, the second cover member 120 may be formed of a colored glass substrate having the cover portion 124. In this exemplary embodiment, the cover portion 124 may be a portion that represents a certain color so that the solar cell 150, interconnectors 142 and 145, etc. are not seen from the outside. Unlike the exterior forming portion 114, the cover portion 124 is positioned on the rear of the solar cell panel 100 having a building-integrated structure and does not require light diffusion, scattering, or the like, and thus may have a specific color.

The second cover member 120 or the cover portion 124 may have such a color that causes the color difference (ΔE^{∗}ab) between the solar cell 150 (particularly, the anti-reflection layer 152 of the solar cell 150) and the second cover member 120 to be 11 or less when the International Commission on Illumination (CIE) Lab (that is, CIE L^{∗}a^{∗}b^{∗}) color coordinates and D65 standard illuminant (midday solar light source) are used. When the color difference (ΔE^{∗}ab) is 11 or less, the solar cell 150, interconnectors 142 and 145, etc. can be kept from being seen from the outside at a certain distance or longer. In this instance, when the International Commission on Illumination (CIE) Lab (that is, CIE L^{∗}a^{∗}b^{∗}) color coordinates and D65 standard illuminant are used, the luminance (L^{∗}) may be 50 or less, thus giving a relatively dark color. Thus, the solar cell 150,
interconnectors 142 and 145, etc. can be effectively kept from being seen from the outside. However, the present disclosure is not limited thereto, and, when the International Commission on Illumination (CIE) Lab (that is, CIE L^{∗}a^{∗}b^{∗}) color coordinates and D65 standard illuminant are used, the luminance (L^{∗}) may be greater than 50, thus giving a relatively bright color.

In this instance, the color of the cover portion 124 may be the same as or different from the color of the exterior forming portion 114. More particularly, the cover portion 124 may be not transparent, translucent, or the like, and may have an achromatic color except for white, an opaque color, or a color of the same base as the solar cell 150. For example, the color of the cover portion 124 may be black, gray, blue, green, brown, a color of the same base as the solar cell 150 (particularly, the anti-reflection layer 152 of the solar cell 150), or a mixed color thereof. Since white has a high lightness, it may be difficult to form the cover portion 124 by using it. For example, if the cover portion 124 is formed in a color of the same base as the solar cell 150, color uniformity is achieved. Thus, the solar cell panel 100 may be entirely uniform in color, thereby giving a better aesthetic appeal. However, the present disclosure is not limited thereto. Various colors other than the above-mentioned colors may be used, as long as these colors have a lower lightness than that of the exterior forming portion 114 or a lower light transmittance than that of the first base member 112 and/or second base member 122.

As described above, when the second cover member 120 has a certain color to keep the solar cell 150 from being seen, the color of the sealing member 130 does not need to be changed. If the sealing member 130 comprises a colorant (for example, carbon black) for changing the color, there may be a problem such as a deterioration of the insulating properties of the sealing member 130.

As an example, in this exemplary embodiment, the cover portion 124 may be made of an oxide ceramic composition. Thus, the first and second cover members 110 and 120 may be formed by the same or similar manufacturing process, thereby simplifying the manufacturing process. In this instance, the above description of the oxide ceramic composition constituting the exterior forming portion 114 and the first cover member 110 may apply to the oxide ceramic composition constituting the cover portion 124 and the second cover member 120.

However, the present disclosure is not limited to this, and the cover portion 124 may be made of other materials than an oxide ceramic composition, which will be described in detail later with reference to FIG. 12.

In the above description, it is exemplified that the second cover member 120 comprises the second base member 122 composed of a glass substrate and the cover portion 124, but the present disclosure is not limited thereto. For example, the cover portion 124 may be composed of a metal layer (e.g., silver or aluminum layer coated in black) and deposited to the second base member 122 composed of a glass substrate. Alternatively, the second cover member 120 may be formed as a single, integrated member without the second base member 122 and the cover portion 124. For example, the second cover member 120 may be composed of a metal plate (for example, a steel plate). Besides, the second cover member 120 or the second base member 122 may be composed of a sheet containing resin (for example, polycarbonate (PC), polyethylene terephthalate (PET), ethylene tetrafluoroethylene (ETFE), polytetrafluoroethylene (PTFE), etc.), fiber reinforced plastic, etc. A separate cover portion 124 may be formed on the second based member 122 composed of such a sheet or the like, or a pigment may be included in the second base member 122 to produce a certain color. The second base member 122 composed of such a sheet or the like may be made up of a single layer or multiple layers.

In the above description, it is exemplified that the second cover member 120 is composed of a member colored in a certain color. However, the present disclosure is not limited thereto, and the second cover member 120 may have various properties including translucency, non-translucency, or reflectivity. Besides, other various modifications are possible.

In FIG. 3, it is exemplified that the exterior forming portion 124 is positioned on an outer surface of the first cover member 110, and the cover portion 124 is positioned on an outer surface of the second cover member 120. Since the exterior forming portion 114 is positioned on an outer surface of the first cover member 110, it may prevent or minimize glare which may occur when the solar cell panel 100 is applied to the building 1. The cover portion 124 may be positioned on an outer surface of the second cover member 120, close to the rear of the solar cell panel 100. However, the present disclosure is not limited to this. Thus, the exterior forming portion 114 may be positioned on at least one of inner and outer surfaces of the first cover member 112, and/or the cover portion 124 may be positioned on at least one of inner and outer surfaces of the second cover member 120. As described above, a light diffusion portion LD with irregularities, a texture, etc. may be formed on the other side where the exterior forming portion 114 or cover portion 124 is not formed. Besides, other various modifications are possible. In FIG. 4, it is exemplified that the exterior forming portion 114 and the cover portion 124 are formed in one color over the entire areas of the first and second cover members 110 and 120, respectively. Also, it is exemplified that one exterior forming portion 114 and one cover portion 124 each form one cover area CA. In this instance, the cover area CA refers to an area that is seen to have the same color, image, pattern, feel, texture, or the like so as to realize a certain color, image, pattern, feel, texture, or the like. However, the present disclosure is not limited to this.

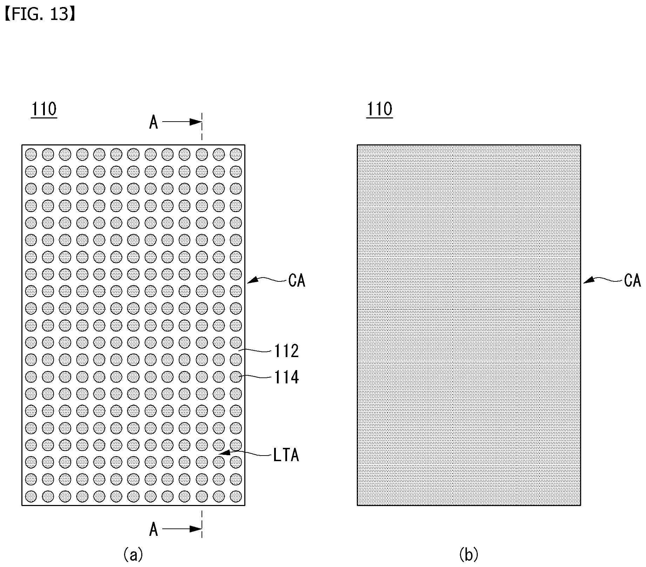

Accordingly, at least one between the exterior forming portion 114 and the cover portion 124 may be formed only at part of the first or second cover member 110 or 120. Also, at least one between the exterior forming portion 114 and the cover portion 124 may comprise a portion having two or more colors. Also, even if the exterior forming portion 114 or cover portion 124 is formed only in part of the cover area CA, the cover area CA may be seen as one area. These examples will be described in more detail later with reference to FIGS. 13, 16, 19, and 20. Besides, other various modifications are possible.

According to this exemplary embodiment, in the exterior forming portion 114 provided on the first cover member 110, the first average transmittance, which is the average light transmittance in the infrared region, is equal to or higher than the second average transmittance, which is the average light transmittance in the visible light region. Thus, the power output of the solar cell panel 100 can be kept high while improving the exterior appearance and aesthetic appeal of the solar cell panel 100. The exterior forming portion 114 may be made of an oxide ceramic composition to effectively prevent glare which may occur when the first cover member 110 comprises a glass substrate. Also, when the solar cell panel 100 is viewed from the side, a desired color, image, pattern, feel, texture, etc. can be maintained without a color change or without the exterior forming portion 114 being seen. Also, the second cover member 120 may be colored by the cover portion 124 so as to have a color that keeps the solar cell 150, interconnectors 142 and 145, etc. from being seen, thereby further improving the external appearance of the solar cell panel 100.

On the other hand, in the conventional art, if a colored portion is separately formed on the first or second base member 112 or 122 and not integrated with them, the color of the colored portion may be seen differently from other members when viewed from the side or in a bright circumstance, thereby degrading the aesthetic appeal. In addition, the conventional colored glass has a very low light transmittance, and may greatly reduce the power output of the solar cell panel 100 when applied to the first cover member 110 of the solar cell panel 100.

Hereinafter, a solar cell panel according to another exemplary embodiment of the present disclosure will be described in detail. Detailed descriptions of the same or extremely similar parts as those described above will be omitted, and only different parts will be described in detail. Combinations of the above-described exemplary embodiments and modifications thereof and the following exemplary embodiments and modifications thereof also fall within the scope of the present disclosure.

FIG. 12 is a partial cross-sectional view showing various examples of a second cover member included in a solar cell panel according to another exemplary embodiment of the present disclosure.

Referring to FIG. 12, the second cover member 120 included in the solar cell panel according to this exemplary embodiment may comprise a second base member 122 and a cover portion 124 formed on the second base member 122 and comprising a plurality of cover layers 124a, 124b, 124c, and 124d. The number of cover layers 124a, 124b, 124c, and 124d may be a number enough to produce a specific color, and each cover layer 124a, 124b, 124c, and 124d may be made of various materials such as dielectric material, insulating material, and semiconductor material. As shown in (a) to (c) of FIG. 12, the number of cover layers 124a, 124b, 124c, and 124d may vary. Although (a) to (c) of FIG. 12 illustrate that the plurality of cover layers 124a, 124b, 124c, and 124d are composed of two to four layers, the present disclosure is not limited to this and they may be composed of five or more layers.

For example, in this exemplary embodiment, the cover portion 124 may produce the same or similar color to the anti-reflection layer (reference numeral 152 in FIG. 3; the same applies hereinafter) of the solar cell (reference numeral 150 in FIG. 3; the same applies hereinafter).

In one example, the cover portion 124 may comprise a silicon layer containing silicon that constitutes a photoelectric conversion portion of the solar cell 150, and a dielectric layer or insulating layer disposed on the silicon layer and having the same material and stacked structure as the anti-reflection layer 152. Then, the cover portion 124 may have the same or similar color as the solar cell 150, and thus, the same or similar color as the solar cell 150 can be produced. Accordingly, using such a simple structure, it is possible to effectively keep the solar cell 150, interconnectors 142 and 145, etc. from being seen.

As another example, the cover portion 124 may comprise a plurality of cover layers 124a, 124b, 124c, and 124d, each being made of a metal compound (e.g., metal oxide or metal oxynitride). For example, the plurality of cover layers 124a, 124b, 124c, and 124d may have a stacked structure of multiple insulating layers, each made of an oxide or oxynitride containing silicon, titanium, aluminum, zirconium, zinc, antimony, or copper. If the plurality of cover layers 124a, 124b, 124c, and 124d are made of oxide or oxynitride, the cover portion 124 may further comprise a silicon nitride-containing layer and/or a silicon carbonitride-containing layer within or outside the plurality of cover layers 124a, 124b, 124c, and 124d to prevent problems caused by ultraviolet light, moisture, etc.

For example, if the cover portion 124 comprises a first cover layer 124a made of silicon oxide, a second cover layer 124b positioned over the first cover layer 124a and made of silicon nitride, and a third cover layer 124c positioned over the second cover layer 124b and made of silicon carbonitride, the cover portion 124 may have a blue color. Alternatively, if the cover portion 124 comprises a first cover layer 124a made of zirconium oxide, a second cover layer 124b positioned over the first cover layer 124a and made of silicon oxide, a third cover layer 124c positioned over the second cover layer 124b and made of zirconium oxide, and a fourth cover layer 124d positioned over the third cover layer 124c and made of silicon oxide, the cover portion 124 may have a green color.

According to this exemplary embodiment, the cover portion 124 may be formed by a simple manufacturing process such as deposition, thereby manufacturing the second cover member 120 in a desired color. Although FIG. 12 illustrates that the cover portion 124 is positioned on an inner surface of the second cover member 120, the present disclosure is not limited to this and the cover portion 124 may be positioned on an outer surface of the second cover member 120.

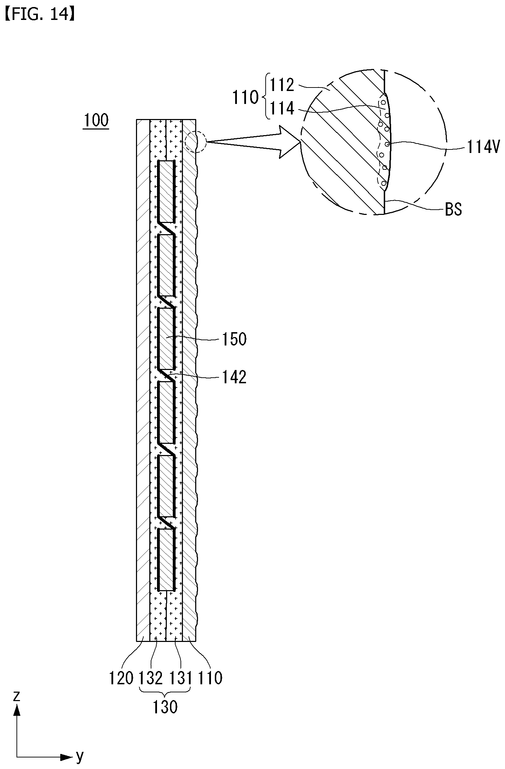

FIG. 13 is a plan view showing an example of a first cover member included in a solar cell panel according to yet another exemplary embodiment of the present disclosure. FIG. 14 is a cross-sectional view taken along the line A-A of FIG. 13. (a) of FIG. 13 illustrates the actual shape of a first cover member 110 where an exterior forming portion 114 is formed, and (b) of FIG. 13 illustrates the shape of the first cover member 110 when viewed at a certain distance.

Referring to FIGS. 13 and 14, in this exemplary embodiment, an exterior forming portions 114 is formed only at part of the cover area CA in the first cover member 110, and, when viewed at a certain distance, the entire cover area CA may look the same in appearance due to the exterior forming portion 114. More specifically, as shown in (a) of FIG. 13, a dotted exterior forming portion 114 may be formed at regular intervals over the entire area of the first base member 112, and, as shown in (b) of FIG. 13, the first base member 112 or cover area CA where the exterior forming portion 114 is positioned may be seen in one color overall, when viewed at a certain distance.

More specifically, if a plurality of exterior forming portions 114 are spaced at regular intervals and cover a certain amount of area or more, the plurality of exterior forming portions 114 may be seen as an integrated whole, with a light transmitting portion LTA interposed between them. That is, the cover area CA where the plurality of exterior forming portions 114 are positioned may be seen in one color due to the plurality of exterior forming portions 114, and, at the same time, sunlight may be transmitted through the light transmitting portion LTA composed of the first base member 112 with high light transmittance positioned between the plurality of exterior forming portions 114 and delivered to the solar cell 150 through the first cover member 110 without significant loss.

For example, the exterior forming portions 114 may have a width or size of 0.2 to 10 mm, and the ratio of the total area of the exterior forming portions 114 to the total area of the cover area CA may be 0.01 or more (for example, from 0.01 to 0.95, more specifically, from 0.05 to 0.5). When the plurality of exterior forming portions 114 are viewed at a certain distance (for example, 1 m) in this range, they may be seen in one color. In this case, if the ratio of the total area of the exterior forming portions 114 to the total area of the cover area CA is 0.5 or less, (that is, the total area of the exterior forming portions 114 is equal to or less than the area of the light transmitting portion LTA), a desired color, image, pattern, feel, texture, etc. may be created with little loss of light passing through the first cover member 110. However, the present disclosure is not limited to this, and the ratio of the total area of the exterior forming portions 114 to the total area of the cover area CA may exceed 0.95 (that is, more than 0.95 and equal to or less than 1).

Alternatively, when the plurality of exterior forming portions 114 are positioned at regular intervals from each other, the plurality of exterior forming portions 114 may be seen as an integrated whole. For example, when the plurality of exterior forming portions 114 are formed in the range of 40 to 300 dpi (dots per inch) (for example, 80 to 300 dpi), the plurality of exterior forming portions 114 may be seen as an integrated whole and create a desired shape, image, pattern, feel, texture, etc. However, the present disclosure is not limited to this, and the density, distribution, etc. of the exterior forming portions 114 may be variously altered.

In this exemplary embodiment, an exterior forming portion 114 is formed to correspond to a part in the thickness direction on one surface of the first base member 112. More specifically, a part of the exterior forming portion 114 is recessed into the first base member 112, and the other part protrudes than a substrate surface BS of the first base member 112 where the exterior forming portion 114 is not formed. The outer surface of the exterior forming portion 114 may be rounded. In this case, the surface roughness at the boundary between the exterior forming portion 114 and the first base member 112 may be greater than the surface roughness of the substrate surface BS. However, the present disclosure is not limited to this, and the exterior forming portion 114 adjacent to the first base member 112 may have other shapes. In an example, the exterior forming portion 114 may have a uniform thickness and made flat. Besides, other modifications are possible.

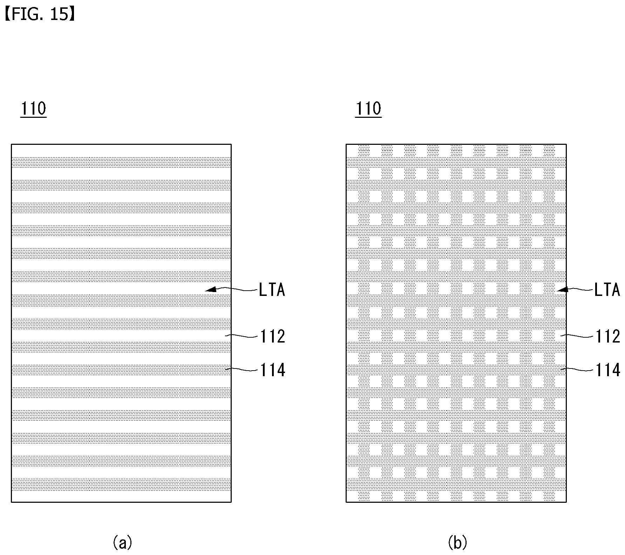

In FIG. 13, it is exemplified that the exterior forming portion 114 constituting the cover area CA has a round dot shape, and the parts of the cover area CA where the dotted exterior forming portion 114 is not positioned are connected as a whole to form a light transmitting portion LTA. However, the present disclosure is not limited thereto, and the exterior forming portion 114 may have a circular shape, an elliptical shape, a polygonal shape (a triangular shape, a rectangular shape, etc.), an irregular shape, or a combination thereof. As another example, as shown in (a) of FIG. 15, a plurality of exterior forming portions 114 may be elongated in one direction so as to have a straight shape so that the plurality of exterior forming portions 114 may form a stripe shape. Then, a light transmitting portion LTA parallel to the plurality of exterior forming portions 114 is positioned between the plurality of exterior forming portions 114, and the exterior forming portions 114 and the light transmitting portion LTA are alternatively arranged in a direction intersecting the one direction. As other example, as shown in (b) of FIG. 15, the exterior forming portions 114 may have a checkered pattern comprising first portions extending in a first direction and second portions extending in a second direction intersecting the first direction. Then, a dot-shaped portion surrounded by the first portions and the second portions may form a light transmitting portion LTA. Besides, the exterior forming portions 114 may have various shapes.

In this exemplary embodiment, when the solar cell panel 100 is viewed with a naked eye at a certain distance or more (for example, 1 m or longer), the solar cell panel 100 may have a uniform color, image, pattern, feel, texture, etc. overall by the first cover member 110. For example, when the solar cell panel 100 is viewed at a distance enough to view the exterior of the building (reference numeral 1 in FIG. 1, the same applies hereinafter), the power output of the solar cell panel 100 may be not reduced greatly while the exterior appearance of the building 1 can be enhanced.

While FIGS. 13 to 15 have been explained with respect to the first cover member 110 and the exterior forming portion 114 included in it, the exterior forming portion 114 or cover portion 124 included in the first and/or second cover member 110 and/or 120 may have the above-described structure.

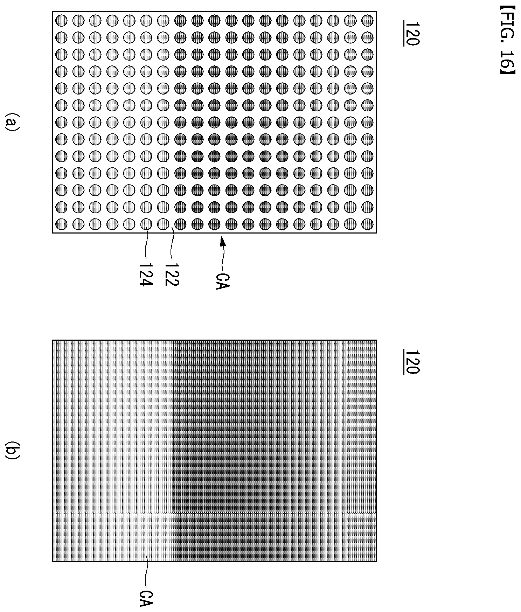

FIG. 16 is a plan view showing an example of a second cover member included in a solar cell panel according to a further exemplary embodiment of the present disclosure. (a) of FIG. 16 shows the actual shape of the second cover member 120 where a cover portion 124 is formed, and (b) of FIG. 16 shows the shape of the second cover member 120 when viewed at a certain distance.

As shown in FIG. 16, the cover portion 124 formed in the second cover member 120 may be formed only at part of the cover area CA, and the entire cover area CA may look the same. However, the present disclosure is not limited to this. That is, the cover portion 124 is only required to keep the solar cell 150, interconnectors 142 and 145, etc. from being seen, rather than forming the exterior appearance. Thus, the cover area CA does not need to look the same. While FIG. 16 illustrates that the cover portion 125 has a dot shape, the present disclosure is not limited to this, and the cover portion 124 may have various shapes.

In the foregoing exemplary embodiments and the exemplary embodiments to be described later, the cover portion 124 may have a lightness or light transmittance lower than that of the exterior forming portion 114, and/or a second cover ratio may be greater than a first cover ratio. For example, the cover portion 124 may have a lower lightness than the exterior forming portion 114, or may have the second cover ratio which is lower than the first cover ratio while having the same color as the exterior forming portion 114 or a color with a lower lightness than that of the exterior forming portion 114. Then, it is possible to keep the solar cell 150, the interconnectors 142 and 145, etc. from being seen. The first cover ratio refers to the ratio of the area of the exterior forming portion 114 to the area of the cover area CA, and the second cover ratio refers to the ratio of the area occupied by the cover portion 124 positioned in the inactive area NA to the area of the inactive area NA.

In this instance, the relatively low lightness may mean a lightness value lower than that of the exterior forming portion 114, and the relatively low light transmittance may mean a light transmittance lower than that of the first base member 112 and/or the second base member 122. In an example, the exterior forming portion 114 of the first cover member 110 and the cover portion 124 of the second cover member 120 may have the same or similar pattern, and at the same time may provide an aesthetic appeal while achieving uniformity in design in the solar cell panel 100.

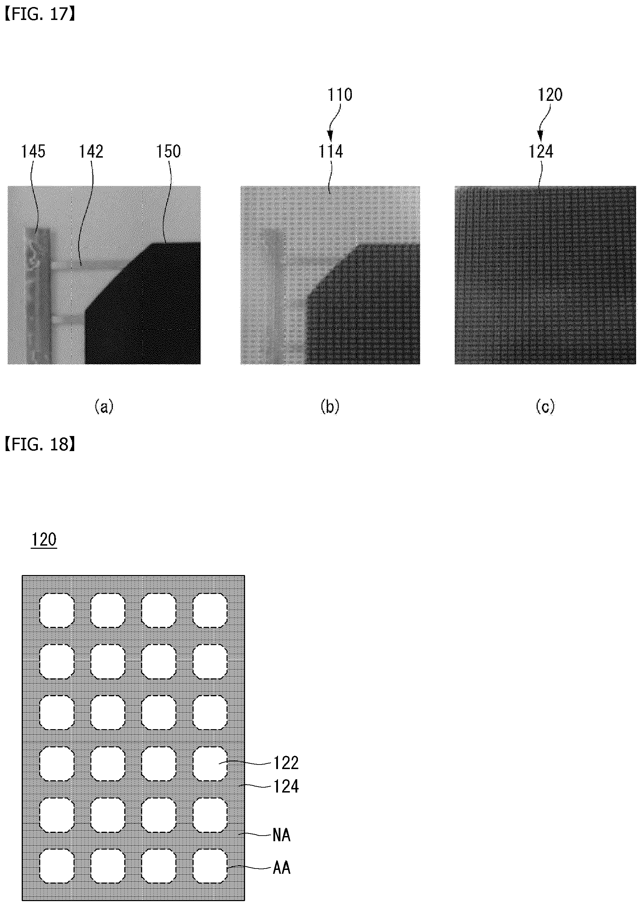

That is, if the first cover member 110 having the exterior forming portion 114 shown in (b) of FIG. 17 is placed over the solar cell 150 shown in (a) of FIG. 17, the boundary of the solar cell 150 and the boundaries of the interconnectors 142 and 145 can be seen to some degree although the color created by the exterior forming portion 114 may be seen. In this instance, if the second cover member 120 having the cover portion 124 is placed too, as shown in (c) of FIG. 17, the color created by the exterior forming portion 114 may be seen, and, at the same time, the boundary of the solar cell 150, interconnectors 142 and 145, etc. may be hardly seen due to interference from the exterior forming portion 14 and cover portion 124.

In this exemplary embodiment, a shield member that shields the interconnectors 142 and 145 may be positioned between the solar cell 150 and interconnectors 142 and 145 and the first sealing member 130. In one example, a shield member may be positioned in such a manner as to block a first interconnector 142 positioned between neighboring solar cells 150 and/or a second interconnector 145 (e.g., bus ribbon) connected to a plurality of solar cell strings block at the ends of the solar cell strings. The shield member may have a specific color (e.g., black, gray, or the same or similar color to the solar cell 150), and be made of a material that has a different reflectivity from the interconnectors 142 and 145 and does not completely block light. The shield member may cohere to the solar cell 150 or the like. In this instance, the term "cohere" refers to a bonding force that allows two layers to be attached to or detached from each other by a physical force at room temperature, which has a different meaning from the term "adhesion" which refers to attaching two layers together by heat treatment and involves damage to one of the two layers when they are separated. When the shield member is fixed to the solar cell 150 or the like by sticking it, it is easy to attach or detach the shield member or adjust its position during the manufacturing process. The shape, structure, material, etc. of the shield member may be variously modified. Alternatively, interconnects 142 and 145 having a certain color (e.g., black, gray, etc.) may be used. Thus, it is possible to more effectively keep the boundaries of the interconnectors 142 and 145 from being seen. As an example, the second cover ratio may be 0.5 to 1. That is, the ratio of the area of the cover portion 124 formed in the inactive area NA to the total area of the inactive area NA may be 0.5 to 1. Within this range of the second cover ratio, it is possible to effectively keep the boundary of the solar cell 150, the boundaries of the interconnector 142 and 145, etc. from being seen.

As an example, the second cover member 120 may be formed over the entire area so as to correspond to the active area AA and the inactive area NA as shown in FIG. 16. Alternatively, the second cover portion 124 may be formed only in a portion corresponding to the inactive area NA but not in the active area AA as shown in FIG. 18. When the cover portion 124 is not formed in the active area AA, the cost for forming the cover portion 124 can be reduced.

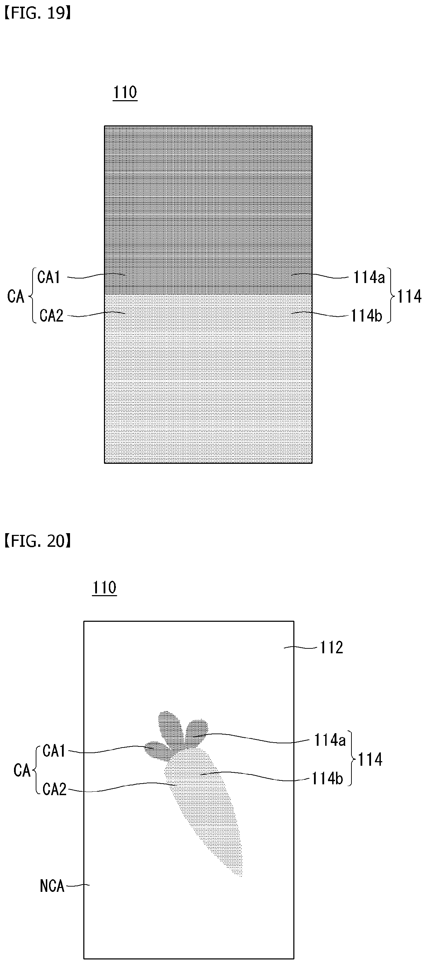

FIG. 19 is a plan view showing a first cover member included in a solar cell panel according to a further exemplary embodiment of the present disclosure.

As shown in FIG. 19, in this exemplary embodiment a plurality of cover areas CA of different colors may be provided. The plurality of cover areas CA of different colors may be positioned adjacent to each other or separately from each other. FIG. 19 illustrates that, as an example, first and second cover areas CA1 and CA2 of different colors are provided by means of first and second exterior forming portions 114a and 114b of two different colors. However, the present disclosure is not limited to the shape, color, number, configuration, etc. of the cover areas CA, and various modifications are possible.

FIG. 20 is a plan view showing a first cover member included in a solar cell panel according to a further exemplary embodiment of the present disclosure.

As shown in FIG. 20, in this exemplary embodiment, a cover area CA may be positioned only in some part of the first cover member 110 or first base member 112, and a non-cover area NCA which is seen to have no color may be positioned in the other part. FIG. 20 illustrates that, as an example, first and second cover areas CA1 and CA2 of different colors are provided by means of first and second exterior forming portions 114a and 114b of two different colors. However, the present disclosure is not limited to the shape, color, number, positions, etc. of the cover areas CA, and various modifications are possible.

While FIGS. 18 to 20 illustrate that the exterior forming portion 114 or cover portion 124 is formed over the entire cover area CA, the exterior forming portion 114 or cover portion 124 may be positioned only in part of the cover area CA, as shown in (a) of FIG. 16, and seen as one cover area CA when viewed at a certain distance or longer.

The features, structures, and effects described in the present disclosure are included in at least one embodiment but are not necessarily limited to a particular embodiment. A person skilled in the art can apply the features, structures, and effects illustrated in the particular embodiment to another embodiment by combining or modifying such features, structures, and effects. It should be understood that all such combinations and modifications are included within the scope of the present disclosure.

## Claims

1. A solar cell panel comprising:
a solar cell;
a sealing member for sealing the solar cell;
a first cover member disposed on the sealing member on one side of the solar cell; and
a second cover member disposed on the sealing member on the other side of the solar cell,
wherein the first cover member comprises a first base member and an exterior forming portion formed on the first base member and made of an oxide ceramic composition, and
wherein a first transmittance, which is the average light transmittance of the exterior forming portion in an infrared region, is equal to or higher than a second transmittance, which is the average transmittance of the exterior forming portion in a visible region.

2. The solar cell panel of claim 1, wherein the exterior forming portion is made of an oxide ceramic composition having an amorphous glass substrate.

3. The solar cell panel of claim 1, wherein, in the exterior forming portion, the first transmittance is higher than the second transmittance.

4. The solar cell panel of claim 3, wherein, in the exterior forming portion, the first transmittance is higher than the second transmittance by 2 % or more.

5. The solar cell panel of claim 1, wherein, in the exterior forming portion, a third transmittance, which is the average light transmittance in an ultraviolet region, is lower than the first and second transmittances.

6. The solar cell panel of claim 5, wherein, in the exterior forming portion, a first difference between the first average transmittance and the second average transmittance is greater than a second difference between the second average transmittance and the third average transmittance.

7. The solar cell panel of claim 1, wherein the exterior forming portion comprises voids to be porous.

8. The solar cell panel of claim 1, wherein the voids have a size of 0.1 um or more.

9. The solar cell panel of claim 1, wherein the surface roughness of the boundary between the first base member and the exterior forming portion, where the exterior forming portion is formed, is higher than the surface roughness of the other part of the first base member where the exterior forming portion is not formed.

10. The solar cell panel of claim 1, wherein the exterior forming portion has a higher refractive index than the first base member or the sealing member, and the exterior forming portion has a thickness of 1 um or more.

11. The solar cell panel of claim 1, wherein the exterior forming portion is formed on part of or the entire first base member, or the exterior forming portion is formed on part of or an entire cover area where the exterior forming portion is seen as an integrated whole.

12. The solar cell panel of claim 1, wherein the first cover member comprises a tempered or semi-tempered glass substrate.

13. The solar cell panel of claim 12, wherein the exterior forming portion comprises a ceramic frit as a primary material, and the exterior forming portion is composed of an integrated portion which constitutes part of the tempered or semi-tempered glass substrate as the ceramic frit is mixed into the tempered or semi-tempered glass substrate.

14. The solar cell panel of claim 12, wherein the first cover member comprises a semi-tempered glass substrate having a surface compressive stress of 60 MPa or less.

15. The solar cell panel of claim 1, wherein the exterior forming portion is formed on one side of the first cover member, and a light diffusion portion is formed on the other side of the first cover member.

16. A solar cell panel comprising:
a solar cell;
a sealing member for sealing the solar cell;
a first cover member disposed on the sealing member on one side of the solar cell; and
a second cover member disposed on the sealing member on the other side of the solar cell,
wherein, when the International Commission on Illumination (CIE) Lab (that is, CIE L^{∗}a^{∗}b^{∗}) color coordinates and D65 standard illuminant are used, the color difference (ΔE^{∗}ab) between the solar cell and the second cover member is 11 or less.

17. The solar cell panel of claim 1, wherein the second cover member comprises a second base member composed of a glass substrate and a cover portion positioned on the second base member, in an inactive area where at least the solar cell is not positioned.

18. The solar cell panel of claim 17, wherein the cover portion comprises a plurality of cover layers made of an oxide ceramic composition or each comprising a dielectric material or insulating material.

19. The solar cell panel of claim 17, wherein the cover portion comprise a silicon layer containing silicon that constitutes a photoelectric conversion portion of the solar cell, and a dielectric layer or insulating layer disposed on the silicon layer and having the same material and stacked structure as an anti-reflection layer positioned on one side of the solar cell.

20. The solar cell panel of any one of claims 1 to 19, wherein the solar cell panel has a building-integrated structure.
